# EUROPEAN PATENT SPECIFICATION

(11) **EP 2 130 407 B1**
(45) Date of publication and mention of the grant of the patent: **30.08.2017**
(21) Application number: 08743811.5
(22) Date of filing: 12.03.2008
(51) Int. Cl.: H05B 33/08

(54) **POWER CONTROL SYSTEM FOR CURRENT REGULATED LIGHT SOURCES**
LEISTUNGSREGLERYSTEM FÜR STROMGESTEUERTE LICHTQUELLEN
SYSTÈME DE COMMANDE DE PUISSANCE POUR DES SOURCES DE LUMIÈRE RÉGULÉES EN COURANT

(30) Priority: 12.03.2007 US 894295 P
(43) Date of publication of application: 09.12.2009
(73) Proprietor: Philips Lighting Holding B.V., 5656 AE Eindhoven (NL)
(72) Inventor: MELANSON, John, L., Austin, TX 78703 (US)
(74) Representative: Verweij, Petronella Daniëlle
(86) International application number: PCT/US2008/056737
(87) International publication number: WO 2008/112820

(56) References cited:
- US-A- 5 315 214
- US-A1- 2005 218 838
- US-A1- 2005 253 533
- BALOGH, LASZLO: "A DESIGN AND APPLICATION GUIDE FOR HIGH SPEED POWER MOSFET GATE DRIVE CIRCUITS" [Online] 2001, TEXAS INSTRUMENTS, INC , SEM-1400, UNITRODE POWER SUPPLY DESIGN SEMINAR, TOPIC II, TI LITERATURE NO. SLUP133 , XP002552367 Retrieved from the Internet: URL:http://focus.ti.com/lit/ml/slup169/slu p169.pdf> [retrieved on 2009-10-26] the whole document
- ZHENYU YU: "3.3V DSP for Digital Motor Control" [Online] June 1999 (1999-06), TEXAS INSTRUMENTS - APPLICATION REPORT SPRA550 , XP002552366 Retrieved from the Internet: URL:http://focus.ti.com/lit/an/spra550/spr a550.pdf> [retrieved on 2009-10-26] abstract page 3 pages 10-11
- INTERNATIONAL RECTIFIER: "Data Sheet No. PD60143-O, IR2127(S)/IR2128(S), Current Sensing Single Channel Driver" INTERNATIONAL RECTIFIER DATA SHEETS, [Online] 8 September 2004 (2004-09-08), pages 1-16, XP002552456 INTERNATIONAL RECTIFIER, EL SEGUNDO, CALIFORNIA, USA Retrieved from the Internet: URL:http://www.irf.com/product-info/datash eets/data/ir2127.pdf> [retrieved on 2009-10-27]
- INTERNATIONAL RECTIFIER: "APPLICATION NOTE AN-978 RevD - HV Floating MOS-Gate Driver ICs" [Online] 23 March 2007 (2007-03-23), INTERNATIONAL RECTIFIER , EL SEGUNDO, CALIFORNIA , XP002552371 Retrieved from the Internet: URL:www.irf.com/technical-info/appnotes/an -978.pdf> [retrieved on 2009-10-26] the whole document
- Texas Instruments: "ADVANCED PFC/PWM COMBINATION CONTROLLERS", , 30 September 2005 (2005-09-30), XP055295194, Retrieved from the Internet: URL:http://www.ti.com/lit/ds/symlink/ucc28 514.pdf [retrieved on 2016-08-12]

## Description

### BACKGROUND OF THE INVENTION

### Field of the Invention

The present invention relates in general to the field of electronics and lighting, and more specifically to a system and method to controlling and/or providing power to current regulated light sources, such as light emitting diode light sources.

### DESCRIPTION OF THE RELATED ART

The following patent application have been filed before and published after the priority date of the present invention and the present application makes reference to them for explaining some embodiments.

US 2009/0085625 will be referred to herein as Melanson III.

US 2008/0272744 will be referred to herein as Melanson IV.

US 2008/0272745 will be referred to herein as Melanson V.

US 2008/0272755 will be referred to herein as Melanson VI.

US 2008/0272747 will be referred to herein as Melanson VII.

US 2008/0272746 will be referred to herein as Melanson VIII.

The closest prior art to consider according to R42(1) EPC is US 2005/218838 A1 which concerns a LED lighting system comprising a LED load, PFC switch, a plurality of LED current control switches and a processor controlling both PFC and LED switches.

The document with title "ADVANCED PFC/PWM COMBINATION CONTROLLERS", XP055295194, from Texas Instruments discloses combined PFC/PWM controllers.

Commercially practical incandescent light bulbs have been available for over 100 years. However, other light sources show promise as commercially viable alternatives to the incandescent light bulb. LEDs are becoming particularly attractive as main stream light sources in part because of energy savings through high efficiency light output, long life, and environmental incentives such as the reduction of mercury.

LEDs are semiconductor devices and are driven by direct current. The brightness of the LED varies in direct proportion to the current flowing through the LED. Thus, increasing current supplied to an LED increases the brightness of the LED and decreasing current supplied to the LED dims the LED.

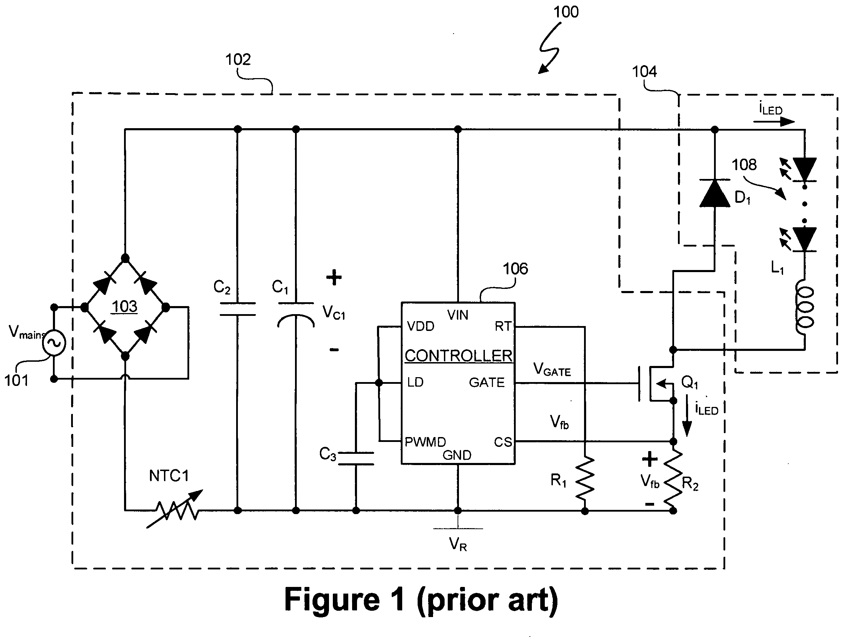

Figure 1 depicts a switching light emitting diode (LED) driver system 100. The LED driver system 100 includes a continuous current mode, buck-based power converter 102 to provide a constant mains voltage Vmains to switching LED system 104. Voltage source 101 supplies an alternating current (AC) input mains voltage Vmains to a full, diode bridge rectifier 103. The voltage source 101 is, for example, a public utility, and the AC mains voltage Vmains is,
for example, a 60 Hz/120 V mains voltage in the United States of America or a 50 Hz/230 V mains voltage in Europe. The rectifier 103 rectifies the input mains voltage Vₘₐᵢₙₛ. The hold-up capacitor C1 holds an approximately direct current (DC) supply voltage V_{C1} across capacitor C1 relative to a reference voltage V_{R.} Supply voltage V_{C1} is also the output voltage of power converter 102 and the input voltage for controller 106. Input filter capacitor C2 provides a high pass filter for high frequency components of the output voltage of rectifier 103. A thermistor NTC1 provides in-rush current protection for power converter 102.

The controller 106 is, for example, a Supertex HV9910B integrated circuit controller available from Supertex, Inc. of Sunnyvale, CA. The supply voltage V_{C1} can vary from, for example, 8V to 450V. Controller 106 incorporates an internal voltage regulator to operate directly from the DC supply voltage V_{C}. The controller 106 provides a gate drive signal from the GATE output node to the n-channel metal oxide semiconductor field effect transistor (MOSFET) Q1. Controller 106 modulates the gate drive signal and, thus, the conductivity of MOSFET Q1 to provide a constant current to switching LED system 104. Controller 106 modifies the average resistance of MOSFET Q1 by varying a duty cycle of a pulse width modulated gate drive signal V_{GATE}. Resistor R₁ and capacitor C₃ provide external connections for controller 106 to the ground reference.

Controller 106 generates and uses feedback to maintain a constant current i_{LED}. Controller 106 receives a current feedback signal V_{fb} representing a feedback voltage V_{fb} sensed across sense resistor R₂. The feedback voltage V_{fb} is directly proportional to the LED current i_{LED} in LEDs 108. If the feedback voltage V_{fb} exceeds a predetermined reference corresponding to a desired LED current, the controller 106 responds to the feedback voltage V_{fb} by decreasing the duty cycle of gate drive signal GATE to increase the average resistance of MOSFET Q1 over time. If the feedback voltage V_{fb} is less than a predetermined reference corresponding to the desired LED current, the controller 106 responds to the feedback voltage V_{fb} by increasing the duty cycle of gate drive signal V_{GATE} to decrease the average resistance of MOSFET Q1 over time.

The switching LED system 104 includes a chain of one or more, serially connected LEDs 108. When the MOSFET Q1 is "on", i.e. conductive, diode D1 is reversed bias and, current i_{LED} flows through the LEDs and charges inductor L₁. When the MOSFET Q1 is "off", i.e. nonconductive, the voltage across inductor L₁ changes polarity, and diode D₁ creates a current path for the LED current i_{LED}. The inductor L₁ is chosen so as to store enough energy to maintain a constant current i_{LED} when MOSFET Q1 is "off".

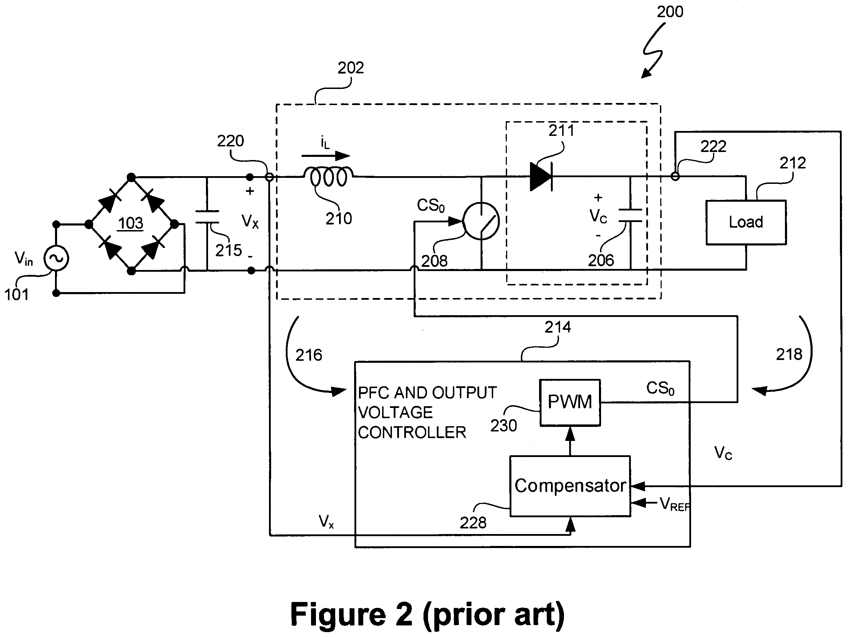

Figure 2 depicts a power control system 200, which includes a switching power converter 202. The rectifier 103 rectifies the input mains voltage Vₘₐᵢₙₛ and supplies a rectified, time-varying, primary supply voltage Vₓ to the switching power converter. The switching power converter 202 provides a power factor corrected, approximately constant voltage power to load 222.

PFC and output voltage controller 214 controls PFC switch 208 so as to provide power factor correction and regulate the output voltage V_{c} of switching power converter 202. The goal of power factor correction technology is to make the switching power converter 202 appear resistive to the voltage source 101. Thus, the PFC and output voltage controller 214 attempts to control the inductor current i_{L} so that the average inductor current i_{L} is linearly and directly related to the primary supply voltage Vₓ. The PFC and output voltage controller 214 supplies a pulse width modulated (PWM) control signal CS₀ to control the conductivity of switch 208. In at least one embodiment, switch 208 is a field effect transistor (FET), and control signal CS₀ is the gate voltage of switch 208. The values of the pulse width and duty cycle of control signal CSₒ depend on two feedback signals, namely, the primary supply voltage Vₓ and the capacitor voltage/output voltage V_{c}. Output voltage V_{c} is also commonly referred to as a "link voltage".

To convert the input voltage Vₓ into a power factor corrected output voltage V_{c}, PFC and output voltage controller 214 modulates the conductivity of PFC switch 208. To regulate the amount of energy transferred and maintain a power factor close to one, PFC and output voltage controller 214 varies the period of control signal CS₀ so that the input current i_{L} tracks the changes in input voltage Vₓ and holds the output voltage V_{C} constant. Thus, as the input voltage Vₓ increases, PFC and output voltage controller 214 increases the period TT of control signal CS₀, and as the input voltage Vₓ decreases, PFC and output voltage controller 214 decreases the period of control signal CS₀. At the same time, the pulse width (PW) of control signal CS₀ is adjusted to maintain a constant duty cycle of control signal CS₀, and, thus, hold the output voltage V_{C} constant. The inductor current i_{L} ramps 'up' when the switch 208 conducts, i.e. is "ON". The inductor current i_{L} ramps down when switch 208 is nonconductive, i.e. is "OFF", and supplies inductor current i_{L} to recharge capacitor 206. The time period during which inductor current i_{L} ramps down is commonly referred to as the "inductor flyback time". Diode 211 prevents reverse current flow into inductor 210. Inductor current i_{L} is proportionate to the 'on-time' of switch 208. In at least one embodiment, the switching power converter 202 operates in discontinuous current mode, i.e. the inductor current i_{L} ramp up time plus the inductor flyback time is less than the period of the control signal CS₀, which controls the conductivity of switch 208. Prodić, Compensator Design and Stability Assessment for Fast Voltage Loops of Power Factor Correction Rectifiers, IEEE Transactions on Power Electronics, Vol. 22, No. 5, Sept. 2007, pp. 1719-1729 (referred to herein as "Prodić"), describes an example of PFC and output voltage controller 214.

In at least one embodiment, the PFC and output voltage controller 214 updates the control signal CS₀ at a frequency much greater than the frequency of input voltage Vₓ. The frequency of input voltage Vₓ is generally 50-60 Hz. The frequency 1/TT of control signal CS₀ is, for example, between 20 kHz and 130 kHz. Frequencies at or above 20 kHz avoid audio frequencies and frequencies at or below 130 kHz avoids significant switching inefficiencies while still maintaining a good power factor of, for example between 0.9 and 1, and an approximately constant output voltage V_{C}.

Capacitor 206 supplies stored energy to load 212 when diode 211 is reverse biased. The capacitor 206 is sufficiently large so as to maintain a substantially constant output voltage V_{c}, as established by a PFC and output voltage controller 214 (as discussed in more detail below). The output voltage V_{c} remains at a substantially constant target value during constant load conditions. However, as load conditions change, the output voltage V_{c} changes. The PFC and output voltage controller 214 responds to the changes in voltage V_{c} by adjusting the control signal CS₀ to return the output voltage V_{c} to the target value. The PFC and output voltage controller 214 includes a small capacitor 215 to filter any high frequency signals from the primary supply voltage Vₓ.

PFC and output voltage controller 214 controls the process of switching power converter 202 so that a desired amount of energy is transferred to capacitor 206. The desired amount of energy depends upon the voltage and current requirements of load 212. To determine the amount of energy demand of load 212, the PFC and output voltage controller 214 includes a compensator 228. Compensator 228 determines a difference between a reference voltage V_{REF,} which indicates a target voltage for output voltage V_{c}, and the actual output voltage V_{c} sensed from node 222 and received as feedback from voltage loop 218. The compensator 228 generally utilizes technology, such as proportional integral (PI) type control, to respond to differences in the output voltage Vc relative to the reference voltage VREF- The PI control processes the error so that the PFC and output voltage controller 214 smoothly adjusts the output voltage Vc to avoid causing rapid fluctuations in the output voltage Vc in response to small error signals. The compensator 228 provides an output signal to the pulse width modulator (PWM) 230 to cause the PWM 230 to generate a control signal CSo that drives switch 208.

An LED lighting system controller, such as controller 106, using a supply voltage that can vary from, for example, 8V to 450V generally requires a more expensive integrated circuit relative to an integrated circuit designed to operate at a fraction of the maximum supply voltage. Using a conventional PFC controller with feedback control, when the power demand of a load quickly decreases, the output voltage Vc will momentarily increase while the PFC controller responds to output voltage feedback by lowering the output voltage. Conventional switching power converters using compensators generally respond relatively slowly to large changes in load power demand. Additionally, conventional PFC controllers often include large and relatively expensive electrolytic capacitors to accommodate voltage spikes.

### SUMMARY OF THE INVENTION

One embodiment of the present invention is defined by claim 1. A light emitting diode (LED) lighting system includes a power factor correction (PFC) and LED drive controller. The controller includes a digital signal processor, coupled to the LED feedback node and configured to: operate from a digital level supply voltage; generate a PFC control signal; and generate an LED current control signal. The controller further includes a first buffer, coupled to the processor, and configured to: operate from a medium level supply voltage. The medium level supply voltage is greater than the digital level supply voltage. The controller is further configured to receive the PFC control signal and convert the PFC control signal into a PFC switch control signal to control conductivity of a high voltage PFC switch. The controller further includes a second buffer, coupled to the processor, and configured to: operate from the medium level supply voltage; receive the LED current control signal; and convert the LED current control signal into an LED current control switch signal to control conductivity of a high voltage LED current control switch.

Another embodiment of the present invention is defined by claim 7. A method includes operating a digital signal processor of a power factor correction (PFC) and output voltage controller from a digital level supply voltage and generating a PFC control signal; and generating an LED current control signal. The method further includes operating a first buffer, coupled to the processor, from a medium level supply voltage. The medium level supply voltage is greater than the digital level supply voltage; receiving the PFC control signal. The method also includes converting the PFC control signal into a PFC switch control signal to control conductivity of a high voltage PFC switch and operating a second buffer, coupled to the processor, from the medium level supply voltage. The method further includes receiving the LED current control signal and converting the LED current control signal into an LED current control switch signal to control conductivity of a high voltage LED current control switch.

In a further example, a light emitting diode (LED) lighting system includes an LED lighting power system. During normal operation of the LED lighting system the LED lighting power system generates a first source voltage relative to a common voltage. The first source voltage is a link voltage. The LED lighting power system includes a switching power supply having a power factor correction (PFC) switch, wherein during normal operation of the LED lighting system, the PFC switch of the LED lighting power system operates at a current node voltage less than or equal to 0.1 times the first source voltage relative to the common voltage reference. The LED lighting power system also includes an LED current control switch, wherein during normal operation of the LED lighting system, the LED current control switch operates at a current node voltage less than or equal to 0.1 times the first source voltage relative to the common voltage reference. The LED lighting system further includes a PFC and output voltage controller coupled to conductivity control nodes of the first and LED drive current switches. During normal operation of the lighting control system, the controller operates from a second source voltage relative to the common voltage and controls conductivity of the PFC switch and the LED current control; and at least one LED coupled to the LED current control switch.

### BRIEF DESCRIPTION OF THE DRAWINGS

The present invention may be better understood, and its numerous obj ects, features and advantages made apparent to those skilled in the art by referencing the accompanying drawings. The use of the same reference number throughout the several figures designates a like or similar element.
Figure 1 (labeled prior art) depicts a switching light emitting diode (LED) driver system
Figure 2 (labeled prior art) depicts a power control system, which includes a switching power converter.
Figure 3 depicts a LED lighting system that includes a common reference node at a common reference voltage.
Figure 4 depicts a LED lighting system.
Figures 5A, 5B, 5C, and 5D depict various switches.
Figure 5E depicts a driver circuit.
Figures 6A and 6B depict switching LED systems.
Figures 7-8 depict graphical relationships between various control signals, sense signals, and currents of the LED lighting system of Figure 4.
Fig. 9 depicts a spread spectrum system.
Figure 10 depicts one embodiment of a feed forward lighting power and control system.
Figure 11 depicts a switching LED system with multiple current sense elements.
Figure 12 depicts a switching LED system with a single current sense element.
(45) Figure 13 depicts a graphical representation of non-overlapping control signals and current sense signals.
Figure 14 depicts a graphical representation of overlapping control signals and current sense signals.
Figure 15 depicts an embodiment of a controller of the lighting system of Figure 3.

### DETAILED DESCRIPTION

A light emitting diode (LED) lighting system includes a PFC and output voltage controller and a LED lighting power system. The LED lighting power system operates from a primary supply voltage derived from a primary power supply. The controller operates from an auxiliary power source supply, which provides an auxiliary voltage less than a link voltage generated by the LED lighting power system relative to a common reference voltage at a common reference node. By utilizing a lower voltage, in at least one embodiment, the controller can be manufactured at a lower cost than a comparable controller supplied by the primary power supply utilized by the LED lighting power system. Additionally, during normal operation of the LED lighting system, a power factor correction (PFC) switch and an LED drive current switch of the LED lighting system, that respectively control power factor correction and LED drive current, are coupled to the common reference node and have control node-to-common node, absolute voltage that allows the controller to control the conductivity of the switches. In at least one embodiment, the PFC switch and the LED drive current switch each have a control node-to-common node, absolute voltage within 15% of the link voltage relative to the common reference voltage. Having a current node voltage within 15% of the absolute value of the link voltage relative to the common reference voltage allows the controller to effectively control the switches.

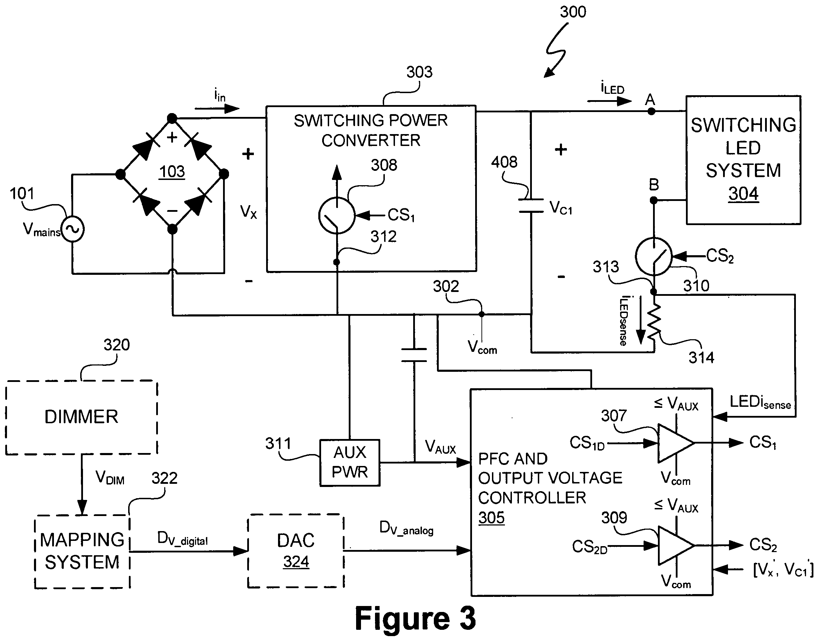

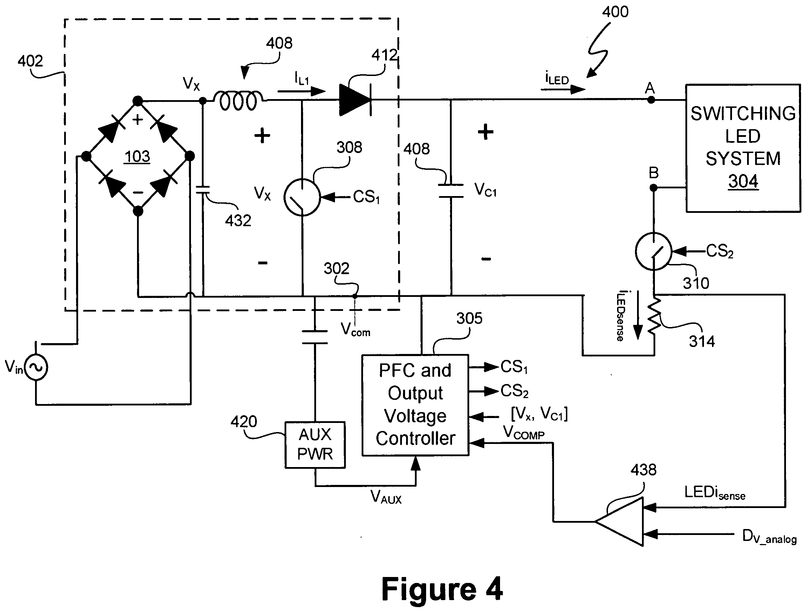

In at least one embodiment, the controller 305 is manufactured in a 12-20 Volt ("V") complimentary metal oxide semiconductor (CMOS) integrated circuit process ("IC Process"), coupled to 200V -500V rated field effect transistors (FETs) external to the integrated circuit (IC) controller. This embodiment is a particularly cost-effective combination of technologies. In a further refinement of the preferred embodiment, the IC Process also includes 5V or lower transistors in the IC controller in addition to the 12V - 20V transistors, allowing for dense digital designs. A digital controller, in .35 micron or finer process technology allows for a very small, cost effective, digital controller. A 12V - 20V process allows for the appropriate driving of the gates of external high-voltage FETs. In at least one embodiment, the IC controller is controller 305 (Figures 3 and 4). The foregoing voltage limits typically indicate that the high voltage devices (which have approximately 12V of gate-source voltage to be fully turned on, and less than 1V to be fully turned off) have sources at nearly the same voltage potential, in order that the same controller can drive both.

An LED lighting system that includes dimming capability can be subject to rapid changes in power demand by a switching LED system load. The switching LED system includes one or more light emitting diodes (LED(s)). For example, if the LED(s) are operating at full intensity and a dimming level of 15% of full intensity is requested, the power demand of the switching LED system is quickly and significantly reduced. In at least one embodiment, the LED lighting system utilizes feedforward control to allow the controller to concurrently modify power demand by the LED lighting power system and power demand of one or more switching LED systems. Thus, in at least one embodiment, the LED lighting system can quickly respond to the lower power demand by reducing power received from a power source, such as a mains source, and use a compensator, such as a proportional integral (PI) type control, to make relatively small corrections to maintain a desired LED lighting system output voltage.

Additionally, in at least one embodiment, the LED lighting system includes multiple switching LED systems, and each switching LED system includes at least one LED. In at least one embodiment, the LED lighting system utilizes a common current sense device to provide a common feedback signal to the controller representing current in at least two of the switching LED systems. In at least one embodiment, utilizing a common current sense device reduces a number of pins of the controller used for feedback and reduces a number of current sense devices.

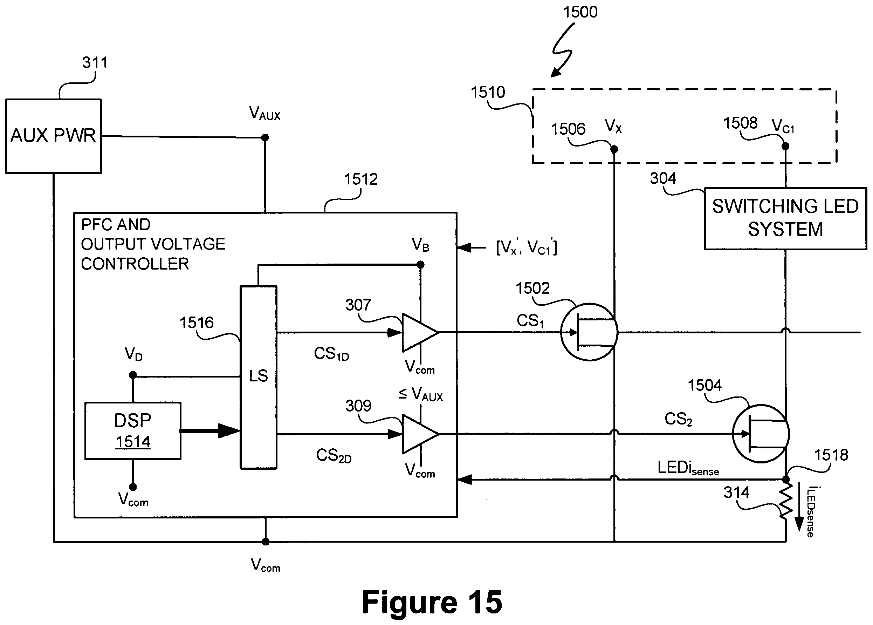

Figure 3 depicts a LED lighting system 300 that includes a common reference node 302 at a common reference voltage V_{com}, such as a ground reference during normal operation. The LED lighting system 300 operates from two supply voltages, Vₓ and V_{AUX}, which are both referenced to the common reference voltage. A third voltage, V_{D} (shown in Figure 15), can be generated internal to the controller 305 and is preferably in the range of 1.5V - 5.0V, depending on the chosen CMOS technology. "Normal operation" refers to the operation of LED lighting system 300 after power has been supplied to the LED lighting system 300 and any initial voltage or current transients have subsided. The LED lighting system 300 generates a link voltage V_{C1}. The PFC switch 308 and LED drive current control switch 310 have absolute, control node-to-common node voltages within 15% of the difference between the absolute link voltage V_{C1} minus the common reference voltage V_{com}, ie. V_{C1}-V_{com}. PFC and output voltage controller 305 (referred to as "controller 305") operates from an auxiliary supply voltage V_{AUX}. The absolute value of auxiliary supply voltage V_{AUX} is less than the absolute value of the link voltage V_{C1}.

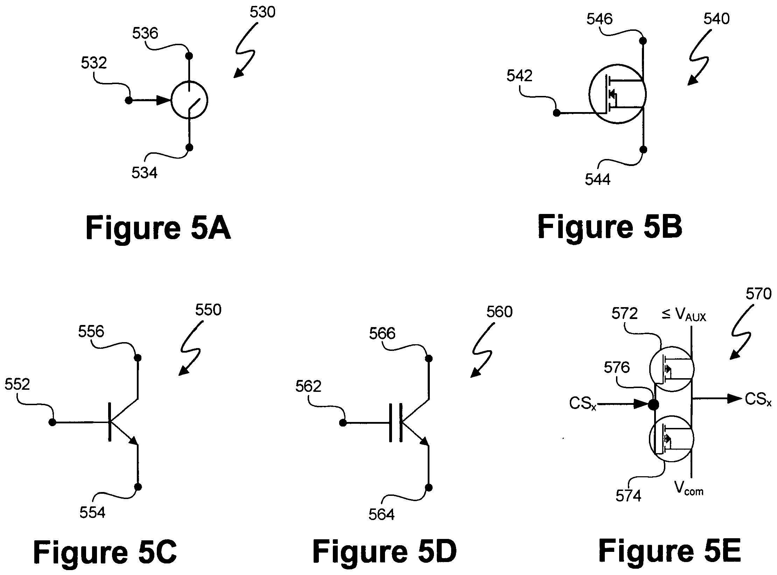

Figures 5A, 5B, 5C, and 5D depict exemplary embodiments of switch 530, which represents one embodiment of switches 308 and 310. Referring to Figure 5A, the nodes of 532, 534, and 536 of generic switch 530 represent respective control, common, and switching nodes. Figures 5B, 5C, and 5D represent embodiments of switch 530. Referring to Figure 5B, switch 540 is an n-channel MOSFET, and gate node 542, source node 544, and drain node 546 respectively represent a control node, a common node, and a switching node. Referring to Figure 5C, switch 550 is a bipolar junction transistor (BJT), and base node 552, emitter node 554, and collector 556 respectively represent a control node, a common node, and a switching node. Referring to Figure 5D, switch 560 is an insulated gate bipolar transistor (IGBT), and gate node 562, emitter node 564, and collector 566 respectively represent a control node, a common node, and a switching node.

Figure 5E depicts an exemplary driver circuit 570, which represents one embodiment of drivers 307 and 309. The source of p-channel FET 572 and the drain of n-channel FET 574 are connected together and provide the output signal CSₓ where CSₓ represents control signals CS₁ and CS₂. The drain of p-channel FET 572 is connected to the high side supply rail voltage, which is less than or equal to auxiliary voltage V_{AUX}. The source of n-channel FET 574 is connected to the low side supply rail voltage V_{com}. FETs 572 and 574 share a gate node 576 to receive the control signal CSₓ.

Referring to Figure 3, diode rectifier 103 rectifies the input mains voltage Vₘₐᵢₙₛ and supplies a rectified, time-varying, primary supply voltage Vₓ to a switching power converter 303. In at least one embodiment, mains voltage Vₘₐᵢₙₛ is a mains voltage such as the mains voltage Vₘₐᵢₙₛ in Figures 1 and 2. Referring to Figure 3, the auxiliary power supply 311 provides low voltage power to the controller 305. Providing low voltage power to the controller 305 allows controller 305 to be manufactured at a lower cost than higher voltage controllers. Additionally, during normal operation of the LED lighting system, a power factor correction (PFC) switch and an LED drive current switch of the LED lighting system, that respectively control power factor correction and LED drive current, are coupled to the common reference node and have control node-to-common node, absolute voltage that allows the controller to control the conductivity of the switches. During normal operation, the switching power converter 303 converts the primary supply voltage Vₓ into an output, link voltage V_{C1}. In at least one embodiment, by referencing controller 305 to the common reference node and establishing the control node-to-common node voltages of switches 308 and 310 within 15% of the voltage difference V_{C1}-V_{com}, controller 305 is able to control the conductivity of the switches 308 and 310 while operating from the auxiliary voltage V_{AUX} of auxiliary power supply 311. In at least one embodiment, the voltages at current nodes 312 and 313 are within +1V of the common reference voltage V_{com}. A current sense resistor may or may not be required in the PFC switch 308, depending on the control mode chosen for the controller 305. In the preferred embodiment, controller 305 is a discontinuous current mode controller and does not use a current sense for controlling power factor correction.

The auxiliary power supply 311 supplies power to controller 305. The auxiliary power supply 311 provides a supply voltage V_{AUX} less than, such as approximately from 1% to 15%, the absolute value of the link voltage V_{C1}. For example, in at least one embodiment, the nominal RMS primary supply voltage Vₓ is 110V, and the supply voltage V_{AUX} is any value within the range of+1V to +15V, such as +1V, +3V, +5V, +12V, or +15V. Because controller 305 is powered by a relatively small supply voltage, controller 305 can be manufactured less expensively than a controller manufactured for higher supply voltages. The voltage V_{AUX} is chosen commensurate with the required drive voltage of the external switch. For an FET, this voltage is typically around 12V. For a bipolar transistor, current drive would often be used, and the voltage would be 1V - 2V.

During normal operation, the switching power converter 303 converts the primary supply voltage Vₓ into an output, link voltage V_{C1}. In at least one embodiment, switching power converter 303 is a boost converter, i.e. link voltage V_{C1} > Vₓ. For a particular dimming level, the switching power converter 303 provides an approximately constant current i_{LED} to LED light source 308. The current i_{LED} varies with dimming levels but, in at least one embodiment, is approximately constant for a particular dimming level. The switching power converter 303 includes switch 308 to control the input current iᵢₙ so that the average input current iᵢₙ is linearly and directly related to the primary supply voltage Vₓ, thereby making the switching power converter 303 appear resistive to voltage source 301. By controlling the input current iᵢₙ, switch 308 also controls the value of link voltage V_{C1}. During normal operation of the LED lighting system 300, the link voltage V_{C1} has an approximately constant value over time and, thus, approximates a DC voltage. In at least one embodiment, the switching LED system 304 includes one or more individual LEDs or one or more parallel coupled strings of LED(s) as, for example, described in more detail with reference to Figures 5A and 5B. The link voltage V_{C1} is typically in the range of 200V - 500V, depending on the AC mains voltage Vₘₐᵢₙₛ.

Controller 305 generates PFC control signal CS₁ to control the conductivity of switch 308. Controller 305 includes a buffer 307 to provide the drive current for PFC control signal CS₁. Controller 305 generates a digital PFC control signal CS_{1D} that is amplified by buffer 307 to generate PFC switch control signal CS₁. Buffer 307 operates from a high side voltage supply rail of less than or equal to auxiliary voltage V_{AUX} and from a low side voltage supply rail of common voltage V_{com}. Controller 305 adjusts the pulse width of PFC control signal CS₁ to increase as the primary supply voltage Vₓ increases and to decrease as primary supply voltage Vₓ decreases to provide power factor correction. Controller 305 maintains a duty cycle of PFC control signal CS₁ while adjusting the pulse width of PFC control signal CS₁ to maintain an approximately constant link voltage V_{C1}. Controller 305 receives feedback signal Vₓ' to detect the value of voltage Vₓ. Controller 305 also receives feedback signal V_{C1}' to detect the value of voltage V_{C1}. Controller 305 uses the value of detected feedback signals Vₓ' and V_{C1}' to adjust PFC control signal CS₁ so that switching power converter 303 provides power factor correction and maintains an approximately constant link voltage V_{C1}.

The controller 305 can be implemented to generate the PFC control signal CS₁ in any of a variety of ways, such as the exemplary ways described in Melanson IV, Melanson V, and Melanson VII. The feedback signals Vₓ' and V_{C1}' can be generated in any of a variety of ways, such as the exemplary ways described in Melanson V, Melanson VI, and Melanson VIII.

Controller 305 generates an LED current control switch signal CS₂ to modulate the conductivity of LED drive current control switch 310. Controller 305 generates a digital LED current control signal CS_{2D} that is amplified by buffer 309 to generate LED current control switch control signal CS₂. Controller 305 includes a buffer 309 to provide the drive current for LED current control switch signal CS₂. Buffer 309 operates from a high side voltage supply rail of less than or equal to auxiliary voltage V_{AUX} and from a low side voltage supply rail of common voltage V_{com}. In at least one embodiment, LED current control switch signal CS₂ is a duty cycle modulated gate drive signal. The duty cycle modulated gate drive signal modulating the conductivity of switch 310 controls the LED current i_{LED} supplied by switching power converter 303. The current i_{LED} serves as the drive current for switching LED system 304. Adjusting the current i_{LED} modifies the intensity of switching LED light system 304. The controller 305 modulates the conductivity of switch 310 so that an average LED current i_{LED} causes each LED in the switching LED system 304 to illuminate at a desired intensity level. In a non-dimmed configuration of LED lighting system 300, the desired intensity level is, for example, the full (100%) rated intensity of the LED(s) of the switching LED system 304 or zero (0) intensity (off).

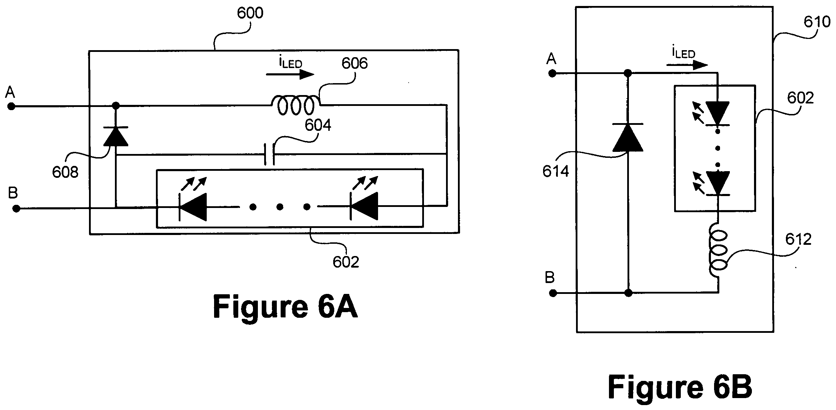

As subsequently described in more detail, to regulate the LED drive current i_{LED}, the controller 305 receives a LED feedback signal LEDiₛₑₙₛₑ from a current sense device 314. In at least one embodiment, the feedback signal LEDiₛₑₙₛₑ is the current i_{LED} or a scaled version of the current i_{LED}. In another embodiment, the feedback signal LEDiₛₑₙₛₑ is a voltage that is directly proportional to the current i_{LED}. The controller 305 responds to the feedback signal LEDiₛₑₙₛₑ by modifying the current delivered to the switching LED system 304 to maintain a desired LED current i_{LED} and desired link voltage V_{C1}. The current sense device 314 can be any device capable of sensing the LED current i_{LED}. In at least one embodiment, current sense device 314 is a resistor, and the feedback signal LEDiₛₑₙₛₑ is a voltage sensed across the resistor. In at least one embodiment, the feedback signal LEDiₛₑₙₛₑ is sensed by a magnetic current sensor in the proximity of current flowing through an inductor (such as inductor 606 of Figure 6A or inductor 612 of Figure 6B) in switching LED system 304. In at least one embodiment, current sense device 314 is a current mirror circuit. Current mirrors are generally not used in high voltage applications. Controller 305 can generate LED current control switch signal CS₂ in any of a variety of ways. Melanson III describes an exemplary system and method for generating LED current control switch signal CS₂.

In at least one embodiment, LED lighting system 300 can dim the LED(s) of switching LED system 304, i.e. adjust the intensity of the LED(s) of switching LED system 304, in response to a dimmer signal D_{V} The dimmer signal D_{V} can be a digital dimming signal D_{V_digital} or an analog dimming signal D_{V_analog} indicating a dimming level for switching LED system 304. Values of dimmer signal Dv function as a target reference and are compared with LEDiₛₑₙₛₑ external to controller 305 or an integral part of an integrated circuit version of controller 305. In at least one embodiment, the controller 305 adjusts LED current control switch signal CS₂ to minimize a difference between the comparison between the dimmer signal D_{V} and the feedback signal LEDiₛₑₙₛₑ.

In at least one embodiment, the dimmer signal Dv represents a mapping of a conventional, duty cycle modified dimmer signal to predetermined values different than the dimming level represented by the dimmer output signal value. In at least one embodiment, a conventional dimmer 320 generates a dimming signal V_{DIM}- The dimming signal V_{DIM} is, for example, a duty cycle modified (i.e. phase-cut) analog signal whose duty cycle or phase angle represents a dimming level. Mapping system 322 includes a lighting output function that converts the dimmer levels indicated by dimming signal V_{DIM} to a digital dimming signal D_{V_digital} having values that map measured light levels to perception based light levels. In at least one embodiment, controller 305 uses the digital dimming signal D_{V_digital} directly to generate LED current control switch signal CS₂. In at least one embodiment, digital-to-analog converter (DAC) 324 converts the digital dimming signal D_{V_digital} into a corresponding analog dimming signal D_{V_analog}. The digital and analog versions of dimming signal Dv are generically referred to here as dimming signal D_{V}. Dimmer 320, mapping system 322, and DAC 324 are shown in "dashed lines" because dimming is optional for LED lighting system 300.

Figure 4 depicts a LED lighting system 400, which represents one embodiment of LED lighting system 300. LED lighting system 400 includes switching power converter 402 to convert the rectified input voltage Vₓ into an approximately DC link voltage Vci. Switching power converter 402 and controller 305 also provide power factor correction. The switching power converter 402 includes a switch 308 that turns 'on' (conducts) and turns 'off (nonconductive) in response to a PFC control signal CS₁ generated by PFC and output voltage controller 305. When switch 308 is 'on', inductor 408 energizes with the current I_{L1} from the full-bridge diode rectifier 103. When switch 308 is 'off, the inductor 408 drives current I_{L1} through diode 412 to charge capacitor 408. The PFC control signal CS₁ varies the duty cycle of switch 308 so that the DC voltage link voltage V_{C1} on storage capacitor 408 averages to a desired value of DC voltage Vci. In at least one embodiment, steady state voltage V_{C1} has an average value in the range of 200 V to 400 V. In at least one embodiment, current I_{L1} represents current iᵢₙ of Figure 3. PFC and output voltage controller 305 operates as previously described to control the duty cycle of switch 308 such that current I_{L1} is linearly proportional to the input voltage Vₓ. Capacitor 432 provides filtering to smooth inductor current I_{L1} so that the average inductor current I_{L1} is sinusoid in phase with input signal Vₓ.

Controller 305 generates LED current control switch signal CS₂ based on the value of the comparator 438 output signal V_{comp}. In at least one embodiment, comparator output signal V_{comp} is a voltage representing a logical "1" if the value of feedback signal LEDiₛₑₙₛₑ is greater than an analog value of dimmer signal D_{V_analog}. Otherwise, the value of comparator output signal V_{comp} is a logical "0". The dimmer signal D_{V} is a target reference value, and controller 305 generates controls signal CS₂ to modify the current i_{LED} to minimize differences between feedback signal LEDiₛₑₙₛₑ and dimmer signal D_{V_analog}. The dimmer signal D_{V_analog} is scaled so that when the difference between feedback signal LEDiₛₑₙₛₑ and dimmer signal D_{V_analog} is minimized, the intensity of the LED(s) of switching LED system 304 matches the dimming level indicated by dimmer signal D_{V_analog}. As the dimming level indicated by dimmer signal D_{V_analog} changes, the value of comparator output signal V_{comp} also changes so that controller 305 causes LED current control switch signal CS₂ to track the changes in dimming level indicated by dimmer signal D_{V_analog}. As previously described, in at least one embodiment, controller 305 uses the comparator output signal V_{comp} to generate LED current control switch signal CS₂ as described in Melanson III.

Figures 6A and 6B depict exemplary embodiments of switching LED system 304. Switching LED system 600 includes one or more LED(s) 602. The LED(s) 602 can be any type of LED including white, amber, other colors, or any combination of LED colors. Additionally, the LED(s) 602 can be configured into any type of physical arrangement, such as linearly, circular, spiral, or any other physical arrangement. In at least one embodiment, each of LED(s) 602 is serially connected. Capacitor 604 is connected in parallel with LED(s) 602 and provides filtering to protect the LED(s) 602 from AC signals. Inductor 606 smooths energy from LED current i_{LED} to maintain an approximately constant current i_{LED} when switch 310 conducts. Diode 608 allows continuing current flow when switch 310 opens.

In switching LED system 610, inductor 612 is connected in series with LED(s) 602 to provide energy storage and filtering. Inductor 612 smoothes energy from LED current i_{LED} to maintain an approximately constant current i_{LED} when switch 310 conducts. Diode 614 allows continuing current flow when switch 310 opens. Although two specific embodiments of switching LED system 304 have been described, switching LED system 304 can be any switching LED system.

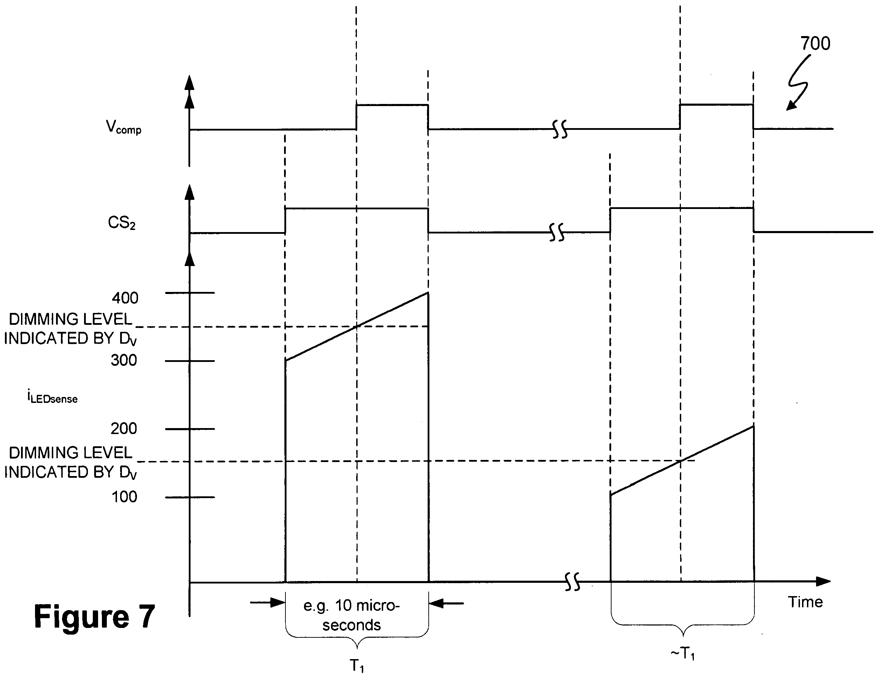

Figure 7 depicts a graphical relationship 700 between the comparator voltage V_{COMP}, LED current control switch signal CS₂, and current i_{LEDsense} (Figure 4). When LED current control switch signal CS₂ is high, switch 310 conducts, and LED current i_{LED} increases. When the comparator voltage V_{COMP} goes high, PFC and output voltage controller 305 keeps LED current control switch signal CS₂ high until the comparator voltage V_{COMP} goes low again. In this manner, the average current i_{LEDsense}, and, thus, the average LED current i_{LED}, is responsive to the dimmer signal Dv, and, thus, the intensity of the LED(s) in switching LED system are also responsive to dimmer signal Dv.

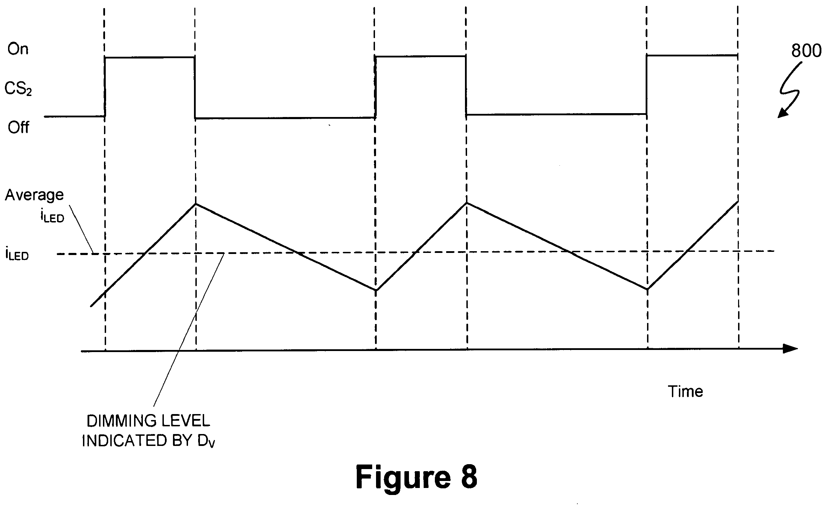

Figure 8 depicts a graphical relationship 800 between LED current control switch signal CS₂ and current i_{LED}. The LED current i_{LED} ramps up when LED current control switch signal CS₂ is high (i.e. causes switch 310 to conduct) and ramps down when LED current control switch signal CS₂ is low (i.e. causes switch 310 to turn 'off'). The average current i_{LED} tracks the dimmer signal Dv. The intensity of switching LED system 304 is approximately directly proportional to the driving LED current i_{LED}.

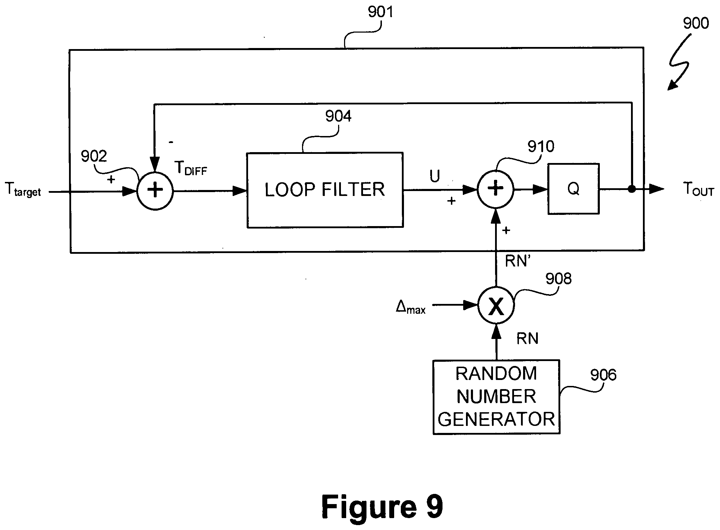

Fig. 9 depicts one embodiment of a spread spectrum system 900. The spread spectrum system can be included as part of controller 305 or can be constructed using separate discrete components as a separate IC. Spread spectrum system 900 can also be implemented as code stored in a computer readable medium and executable by controller 405. In general, spread spectrum system 900 receives an input signal T_{Target} and generates an output signal T_{OUT}. Output signal T_{OUT} randomly varies from input signal T_{Target} within a predetermined range set by Δₘₐₓ, and an average value of output signal T_{OUT} equals input signal T_{Target}. Input signal T_{Target} is, for example, a pulse width of control signals CS₁ and/or CS₂. The value of Δₘₐₓ is, for example, +/-10% of a nominal value of PFC control signal CS₁. Multiple spread spectrum system 900 can be used by controller 305 to spread the spectrum of multiple input signals such as the pulse widths of control signals CS₁ and CS₂.

Spread spectrum system 900 includes a delta-sigma modulator 901. Delta-sigma modulator 901 includes an adder 902 that adds the current value of input signal T_{Target} to a negative value of the previous value of output signal T_{OUT} to generate a difference signal T_{Diff}. In at least one embodiment, spread spectrum system 900 is initialized as startup with output signal T_{OUT} = 0. The difference signal T_{Diff} is processed by loop filter 904 to generate a loop filter output signal U.

The values of delta-sigma modulator output signal T_{OUT} are randomized around the values of input signal T_{Target}. A random number generator 906 generates random output values of random signal RN that are multipled by Δₘₐₓ to generate random signal RN'. During each cycle of spread spectrum system 900, adder 910 adds the random signal RN' to the loop filter output signal U, and quantizer 912 quantizes the sum of RN' and U to generate the quantization output signal T_{OUT}. Random Number Generator 906 has predetermined value ranges set by a range limiting value Δₘₐₓ. In at least one embodiment, RN' varies approximately 10%.

Delta-sigma modulator 901 can be any delta-sigma modulator such as any first order or multi-order delta-sigma modulator described in, for example, Understanding Delta-Sigma Data Converters by Schreier and Temes, IEEE Press, 2005, ISBN 0-471-46585-2 or as available from Cirrus Logic Inc. of Austin, TX, U.S.A. The delta-sigma modulator 901 provides noise-shaping and seeks to consistently generate values of delta-sigma output signal T_{OUT} that minimize the difference between output signal T_{OUT} and difference signal T_{Diff}. Thus, delta-sigma modulator 901 helps ensure that the average output signal T_{OUT} equals the average input signal T_{Target}.

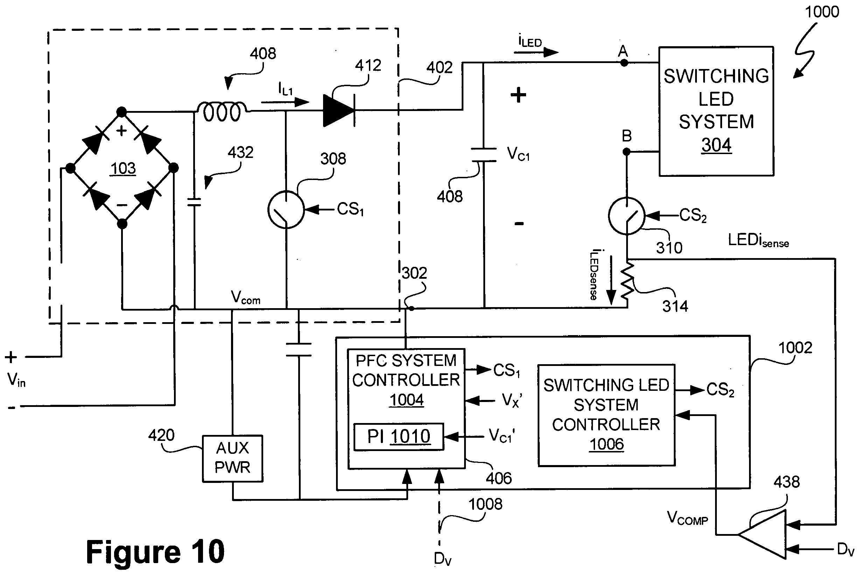

Figure 10 depicts one embodiment of a feed forward lighting power and control system 1000. Power and control system 1000 preferably also includes a common reference node for switches 308 and 310 (through current sense device 314) and controller 1002. Controller 1002 represents one embodiment of controller 305. Controller 1002 is logically divided into two separate control systems, PFC control system 1004 to control power factor correction and regulate the link voltage V_{C1} of switching power converter 402, and switching LED system controller 1006 to control the LED current i_{LED} and, thus, control the intensity (i.e. brightness) of switching LED system 304.

The power and control system 1000 utilizes feed forward control so that PFC controller 1004 can more rapidly respond to changing power demands of Switching LED system light source 304 due to dimming. When dimmer signal Dv indicates a change in the dimming level of light source 304, switching LED system controller 1006 responds to dimming signal Dv by decreasing the pulse width of duty cycle modulated LED current control switch signal CS₂ to reduce the average values of current i_{LED}. Decreasing current i_{LED} reduces the power demand of light source 304.

Feed forward control allows PFC system controller 1004 to anticipate power demand changes of light source 304 due to, for example, dimming. The PFC system controller 1004 is configured to provide a specific output voltage link voltage V_{C1} for a specific dimming level. In at least one embodiment, the controller 1004 responds to comparison signal V_{comp}, which indicates a change in requested dimming level and, thus, a change in power demand by light source 304 by proportionately changing the pulse width of LED current control switch signal CS₂. In at least one embodiment, the dimmer signal Dv is provided directly to controller 1004 as shown by the dashed line 1008. However, providing dimmer signal Dv to controller 1004 may require an extra pin for controller 1002, which generally adds cost to controller 1002. Using feed forward control, the controller 1002 can concurrently modify power demand by the power factor correction control system 1004 and modify power supplied by the switching LED system controller 1006. The term "concurrently" includes short delays due to, for example, processing by controller 1006.

In accordance with changes in a dimming level indicated by the dimmer signal D_{V}, in at least one embodiment, the PFC system controller 1004 includes a proportional integrator (PI) compensator 1010 that receives a feedback signal link voltage V_{C1} representing the link voltage V_{C1} and generates an output signal using a PI transfer function, such as the PI transfer function and system of Melanson IV. However, because the dimmer signal D_{V} anticipates power demand by light source 304, the PFC controller 1004 can concurrently respond to dimming level changes and, the PI compensator 1010, in at least one embodiment, only makes power demand adjustments of, for example, 10% of the total power delivered by the power and control system 1000. Responding more rapidly to power demand changes in light source 304 allows switching power converter 402 to utilize a smaller capacitor value, such as 4.7 µF for capacitor 408 because increases of link voltage V_{C1} are reduced to within the operating characteristics of ceramic, polypropylene, and other capacitors that have advantageous properties relative to electrolytic capacitors such as better temperature characteristics because light source 304 tends to generate higher temperatures better suited for ceramic, polypropylene, and other higher temperature capacitors. In at least one embodiment, controller 1004 generates PFC control signal CS₁ in the same manner as controller 305 so that the changes in the dimming level indicated by dimmer signal D_{V} are commensurate with changes to the power (V_{C1}·iᵢₙ) delivered by switching power converter 402 while maintaining an approximately constant link voltage V_{C1}.

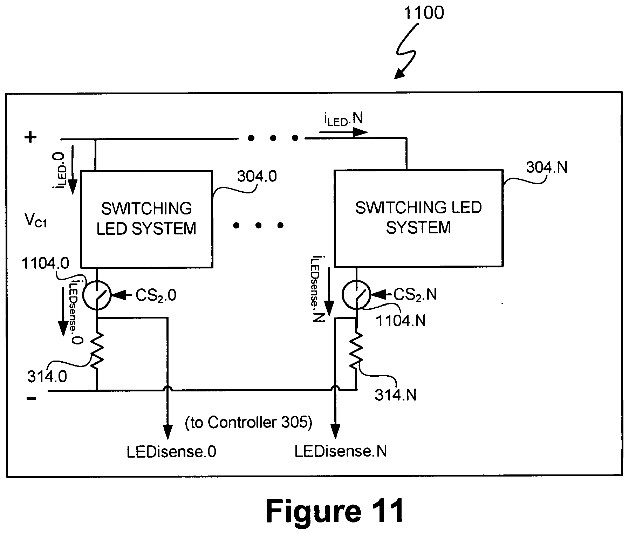

Figure 11 depicts a switching light source bank 1100 having N+1 switching LED systems, where N is an integer greater than or equal to 1. Switching LED system bank 1100 is a substitution for switching LED system 304. In at least one embodiment, each light source 304.x is a light source such as switching LED system 304, where x denotes the x^{th} light source and is, for example, an integer and a member of the set {0, ... , N}. Each of the N+1 light sources includes at least one LED and the number and color of each LED for each light source is a matter of design choice. Each light source 304.x is connected to a respective switch 1104.x, and each switch 1104.x is an n-channel FET. In at least one embodiment, controller 305 independently controls each light source 304.x by generating respective control signals CS₂.0, ... , CS₂.N to control the conductivity of switches 1104.0, ..., 1104N. The average values of the drive currents i_{LED}.0, ..., i_{LED}.N control the respective intensity of LED(s) of switching LED systems 304.0, ..., 304.N. Switching LED systems 304.0, ... , 304.N are connected to respective current sense elements 314.0, ... , 314.N.

The current sense elements 314.0, ... , 314.N can be different or identical. Each current sense element 314.x provides a feedback signal LEDsense.x to controller 305. In at least one embodiment, controller 305 generates each control signal CS₂ₓ in the same manner as the generation of LED current control switch signal CS₂ (Fig. 4). The output signals of LEDiₛₑₙₛₑ.0, ..., LEDiₛₑₙₛₑ.N are fed back to controller 305 to allow controller 305 to adjust the switching frequency of switches 1104.0, ..., 1104.N and, thus, correlate LED drive currents i_{LED}.0, ..., i_{LED}.N with a desired intensity of the LED(s) of light sources 304.0, ..., 304.N. In at least one embodiment, the desired intensity is a dimming level indicated by dimmer signal D_{V}. The type, number, and arrangement of LED(s) in switching LED systems 304.0, ..., 304.N is a matter of design choice and depends, for example, on the range of desired intensity and color temperatures of switching LED systems 304.0, ..., 304.N.

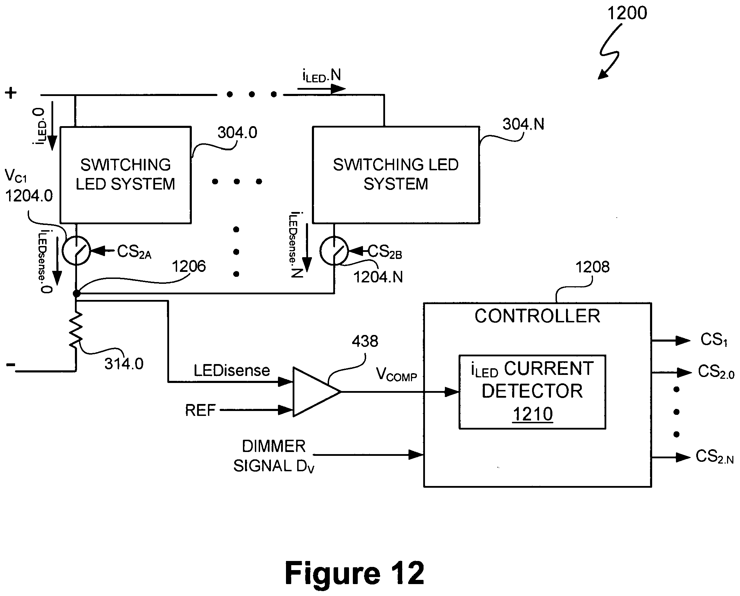

Figure 12 depicts a switching LED system bank 1200, which represents a substitution for switching LED system 304 (Figure 4). One current sense element 314 provides a feedback signal LEDiₛₑₙₛₑ that represents the LED sense currents of all switching LED systems 304.0, ..., 304.N to sense each of the LED sense currents i_{LEDsense}.0, ..., i_{LEDsense}.N for respective switching LED systems 304.0, ..., 304.N. Each of the switches 1204.0, ..., 1204.N have a common current node 1206. At the common current node 1206, all of the LED sense currents i_{LEDsense}.0, ..., i_{LEDsense}.N are combined, and the feedback signal LEDiₛₑₙₛₑ from current sense device 314 represents the combination of all of the LED sense currents i_{LEDsense}.0, ..., i_{LEDsense}.N. In at least one embodiment, feedback signal i_{LEDsense} = l/x-(i_{LEDsense}.0⁺ i_{LEDsense}.1 +, ..., + i_{LEDsense}.N), where "x" is a scaling factor of current sense device 314. Utilizing a common sense element 314 reduces a number of pins for an integrated circuit implementation of controller 1208, which reduces the cost of controller 1208. Controller 1208 represents one embodiment of controller 305.

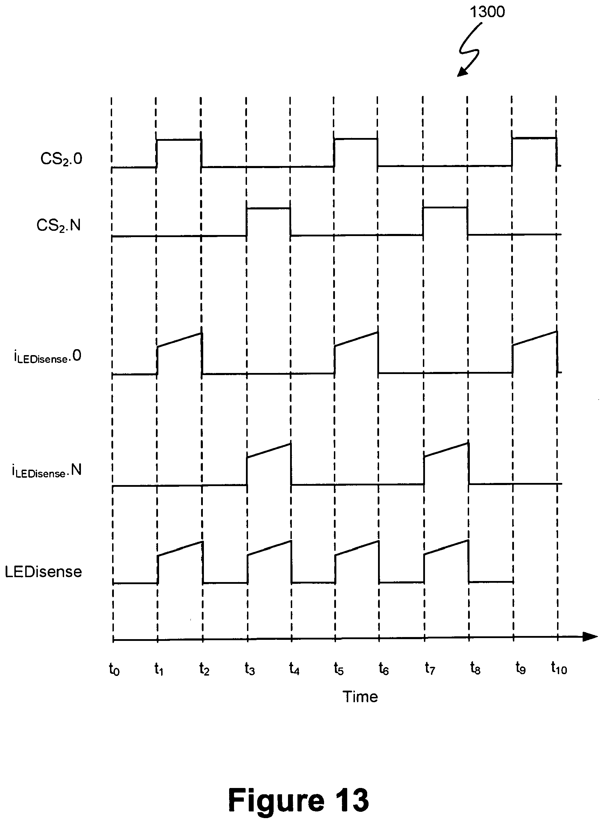

Figure 13 depicts a graphical representation 1300 of non-overlapping control signals and current sense signals. The operation of LED source bank 1200 and controller 1208 (Figure 12) are described in conduction with the signals of Figure 13. Control signals CS₂.0 and CS₂.N represent two exemplary control signals for control signals CS₂.0, ..., CS₂.N. Control signals CS₂.0 and CS₂.N are depicted with a duty cycle of 0.25, i.e. pulse width/period, and non-overlapping pulse widths. During each pulse of control signals CS₂.O and CS₂.N, respective currents i_{LEDsense}.0 and i_{LEDsense}.N flow through respective switches 1204.0 and 1204.N and are combined into the single LEDiₛₑₙₛₑ feedback signal from current sense device 314.

Referring to Figures 12 and 13, controller 1208 includes an LED current detector 1210 that detects and determines the individual LED currents iLED in switching LED systems 304.0, ..., 304.N from the LEDiₛₑₙₛₑ feedback signal. The location in time of each contribution of currents i_{LEDsense}.0 and i_{LEDsense}.N in the feedback signal LEDiₛₑₙₛₑ corresponds to the respective pulses of controls signals CS₂.0 and CS₂.N.

In at least one embodiment, in a dimmable configuration, dimmer signal Dv is used to indicate a dimming level for switching LED systems 304.0, ..., 304.N. Comparator 438 compares the LEDiₛₑₙₛₑ feedback signal to the dimmer signal Dv. Variations in the comparator output signal V_{comp} occur at approximately the same time as the contribution of currents i_{LEDsense}.0 and i_{LEDsense}.N to the feedback signal LEDiₛₑₙₛₑ. Since controller 1208 generates control signals CS₂.0 and CS₂.N, the times at which currents i_{LEDsense.}0 and i_{LEDsense}.N will vary the comparator output signal V_{comp} are also known by LED current detector 1210. By knowing which changes in comparator output signal V_{comp} correspond to each particular current of switching LED systems 304.0, ..., 304.N, controller 1208 can adjust each LED current control switch signal CS₂.0 and CS₂.N in response to the dimmer signal Dv to dim the LEDs of switching LED systems 304.0 and 304.N to the dimming level indicated by dimmer signal D_{V}. In at least one embodiment, controller 1208 generates each LED current control switch signal CS₂.0, ..., CS₂.N in any manner described in conjunction with controller 305.

In at least one embodiment, the switching LED systems 304.0, ..., 304.N are not dimmed. In this embodiment, LED current detector 1210 receives the feedback signal LEDiₛₑₙₛₑ directly. Since controller 1208 generates control signals CS₂.0 and CS₂.N, the times at which currents i_{LEDsense}.0 and i_{LEDsense}.N, LED current detector 1210 detects the contribution of currents i_{LEDsense}.0 and i_{LEDsense}.N during any of the respective times during which respective control signals CS₂.0 and CS₂.N are non-overlapping.

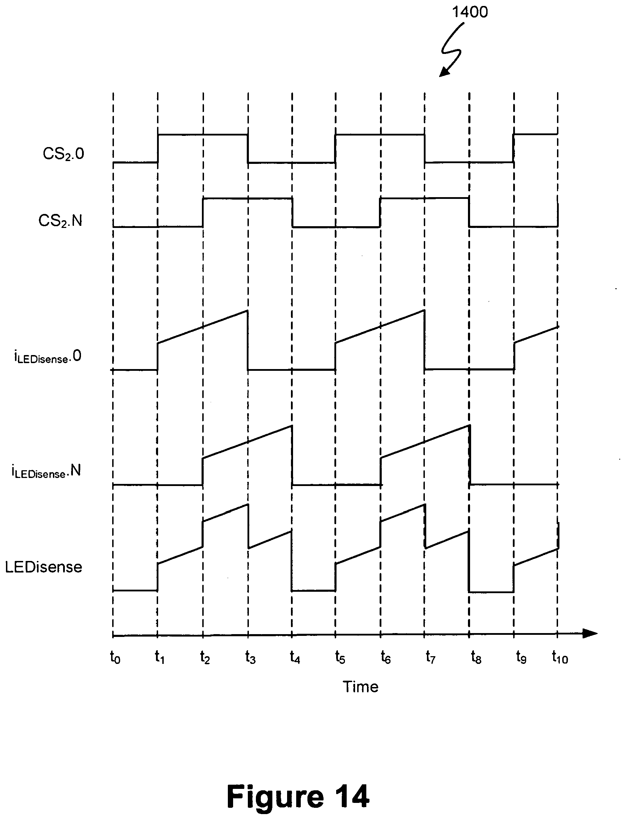

Figure 14 depicts a graphical representation 1400 of overlapping control signals and current sense signals for processing by controller 1208 to generate multiple control signals for multiple light sources from a single feedback signal LEDiₛₑₙₛₑ. The overlapping control signals each have a duty cycle of 0.5. LED current detector 1210 detects the contributions of currents i_{LEDsense}.0 and i_{LEDsense}.N in feedback signal LEDiₛₑₙₛₑ or comparator output signal V_{comp} at times when the control signals CS₂.0 and CS₂.N are non-overlapping. For example, LED current detector 1210 detects the contribution of i_{LEDsense}.0 during times t₁ to t₂, t₅ to t₆, t₉ to t₁₀, and so on. Likewise, LED current detector detects the contribution of i_{LEDsense}.N during times t₃ to t₄, t₇ to t₈, and so on.

Figure 15 depicts lighting system 1500, which is one embodiment of lighting system 300. Lighting system 1500 includes PFC switch 1502, which is an n-channel FET and represents one embodiment of switch 308. PFC switch 1502 operates between the primary supply voltage Vₓ and the common reference voltage V_{com}. PFC switch 1502 does not have to be connected directly to the primary supply voltage Vₓ. In at least one embodiment, PFC switch 1502 is coupled through other components (not shown) to a primary supply voltage node 1506 conducting primary supply voltage Vₓ. Lighting system 1500 also includes LED drive current control switch 1504, which is an n-channel FET and represents one embodiment of switch 310. LED drive current control switch 1504 is coupled through switching LED system 304 to link voltage node 1508. LED drive current control switch 1504 operates between the link voltage V_{C1} and the common reference voltage V_{com}. Voltages Vₓ and V_{C1} are both switching power converter voltages and are collectively referred to as "high" supply voltages 1510 because they represent the highest voltages in the lighting system 1500. Nodes 1506 and 1508 are referred to as high voltage source nodes. PFC switch 1502 is, thus, referred to as a high voltage PFC switch, and LED current control switch 1504 is, thus, referred to as a high voltage LED current control switch. In at least one embodiment, the root mean square (RMS) of high supply voltages 1510 is greater than or equal to 100 V.

The lighting system 1500 also includes PFC and output voltage controller 1512, which in at least one embodiment is identical to controller 305. PFC and output voltage controller 1512 operates from at least two different voltages, which are lower than the high voltages 1510. Output buffers 307 and 309 operate between voltages V_{B} and the common reference voltage. Voltage V_{B} is less than or equal to auxiliary voltage V_{AUX} and greater than or equal the digital voltage reference V_{D}. The voltage V_{B} is set to be sufficient to drive the gates of switches 1502 and 1504 and, thus, control the conductivity of switches 1502 and 1504. Voltage V_{B} is referred to as a "medium level" supply voltage. In at least one embodiment, the medium level supply voltage is in the range of 8 V to 50 V.

The lighting system 1500 also includes a digital signal processor (DSP) 1514 to generate PFC control signal CS_{1D} and LED current control signal CS_{2D}. The DSP 1514 is coupled to an LED feedback node 1518. DSP 1514 operates between a digital supply voltage V_{D} and the common reference voltage V_{com}. The digital supply voltage V_{D} is sufficient to operate the digital components of DSP 1514 and is, for example, in the range of 3 V to 8 V. A level shifter (LS) 1516 level shifts the digital PFC control signal CS_{1D} and digital LED current control signal CS_{2D} from DSP 1514 to a level sufficient to control the conductivity of respective buffers 307 and 309. The digital supply voltage V_{D} can be a stepped down version of the auxiliary voltage V_{AUX} generated internally by controller 1512.

Thus, although the controller 1512 operates from a digital voltage V_{D}, and an auxiliary voltage V_{AUX} and the switches operates from high voltages 1510, the lighting system 1500 has a common reference voltage V_{com} to allow all the components of lighting system 1500 to work together. By operating from auxiliary voltage V_{AUX}, the controller 1512 can be fabricated using lower cost fabrication techniques than a controller operating from the high voltages 1510.

Thus, in at least one embodiment, a LED lighting system controller operates from a supply voltage V_{AUX} less than a link voltage V_{C1} generated by the LED lighting power system relative to a common reference voltage at a common reference node. By utilizing a lower voltage, in at least one embodiment, the controller can be manufactured at a lower cost than a comparable controller supplied by the primary power supply utilized by the LED lighting power system. Additionally, during normal operation of the LED lighting system, a power factor correction (PFC) switch and an LED drive current switch of the LED lighting system, that respectively control power factor correction and LED drive current, are coupled to the common reference node and have control node-to-common node, absolute voltage that allows the controller to control the conductivity of the switches. In at least one embodiment, the PFC switch and the LED drive current switch each have a control node-to-common node, absolute voltage within 15% of an absolute value of the link voltage relative to the common reference voltage. In at least one embodiment, the LED lighting system utilizes feed forward control to concurrently modify power demand by the LED lighting power system and power demand of one or more switching LED systems. In at least one embodiment, the LED lighting system utilizes a common current sense device to provide a common feedback signal to the controller representing current in at least two of the switching LED systems.

Although the present invention has been described in detail, it should be understood that various changes, substitutions and alterations can be made hereto without departing from the spirit and scope of the invention as defined by the appended claims.

## Claims

1. A light emitting diode, LED, lighting system comprising:
at least one LED load (304, 304.0-304.N) including at least one LED (602); a LED feedback node (313) adapted to provide a LED current feedback signal (LEDiₛₑₙₛₑ) representing at least one current level in the at least one LED load and;
a PFC switch (308, 1502);
a LED current control switch (310, 1504) adapted to control the current in the at least one LED load;
an integrated circuit power factor correction, PFC, and LED drive controller (305, 1512), **characterised in that** the controller comprises:
a digital signal processor (DSP), coupled to the LED feedback node (313), and configured to:
operate from a digital level supply voltage;
generate a PFC control signal (CS_{1D}); and
generate an LED current control signal (CS_{2D});
a first buffer (307), coupled to the digital signal processor, and configured to:
operate from a medium level supply voltage (Vₐᵤₓ),
wherein the medium level supply voltage is greater than the digital level supply voltage;
receive the PFC control signal (CS_{1D}); and
convert the PFC control signal (CS_{1D}) into the PFC switch control signal (CS₁) to control the conductivity of the PFC switch; and
a second buffer (309), coupled to the digital signal processor, and configured to:
operate from the medium level supply voltage;
receive the LED current control signal (CS_{2D}); and
convert the LED current control signal (CS_{2D}) into an LED current control switch signal (CS₂) to control the conductivity of the LED current control switch.

2. The LED lighting system of claim 1 further comprising:
a common voltage reference node (V_{com});
a first voltage source node adapted to conduct a primary supply voltage (Vₓ);
a second voltage source node adapted to conduct a link voltage (V_{C1}) of the LED lighting system;
wherein the PFC switch (308, 1502) is coupled to the common voltage reference node (V_{com}) and the first voltage source node; and
wherein the LED current control switch (310, 1504) is coupled to the common voltage reference node (V_{com}) and the second voltage source node;
wherein, during normal operation of the LED lighting system, the PFC switch and an LED current control switch have respective control node-to-common node, absolute voltages that allow the integrated circuit PFC and LED drive controller to control the conductivity of the switches and provide power factor correction and supply an approximately constant current to the at least one LED load for each dimming level indicated by a dimmer signal (D_{V}).

3. The LED lighting system of claim 2 wherein the control node-to-common node, absolute voltages of the PFC switch (308, 1502) and the LED current control switch (310, 1504) are less than or equal to 0.15 times a voltage at the second voltage source node relative to a voltage at the common voltage reference node (V_{com}).

4. The LED lighting system of claim 2 wherein:
the PFC switch (308, 1502) and the LED current control switch (310, 1504) are members of the group consisting of: field effect transistors and insulated gate bipolar transistors.

5. The LED lighting system of claim 2 or 3 further comprising:
a current sense device (314) coupled to the LED current control switch (310, 1504) and the common voltage reference node (V_{com}), wherein during normal operation of the LED lighting system a voltage across the current sense device (314) is less than or equal to 0.15 times a voltage at the second voltage source node relative to the voltage at the common voltage reference node (V_{com}) and wherein the current sensing device (314) is configured to provide the LED current signal for controlling the LED current control switch.

6. The LED lighting system of claim 5 further comprising:
a plurality of LED current control switches (1104.0-1104.N, 1204.0-1204.N) including the LED current control switch, wherein each LED current control switch is configured to control current to a respective one of a plurality of the at least one LED load (304, 304.0-304.N) and is coupled to the common voltage reference node (V_{com}), the second voltage source node, and the integrated circuit PFC and LED drive controller; and
wherein the current sense device (314) is coupled to the LED current control switches, and wherein, during normal operation of the lighting system, the current sense device (314) is configured to sense the current in all of the LED current control switches and to provide the LED current signal (LEDiₛₑₙₛₑ) for use by the integrated circuit PFC and LED drive controller to control current in all of the LED current control switches.

7. A method for controlling a PFC switch (308, 1502) and a LED current control switch (310, 1504) of a light emitting diode, LED, lighting system, wherein the LED lighting system comprises at least one LED load (304, 304.0-304.N) and a LED feedback node (313) adapted to provide a LED current feedback signal (LEDiₛₑₙₛₑ) representing at least one current level in the at least one LED load, wherein the at least one LED load includes at least one LED, **characterized in that** the method comprises: operating a digital signal processor (DSP) of an integrated circuit power factor correction, PFC, and LED drive controller (305, 1512) from a digital level supply voltage by performing the steps of:
generating a PFC control signal (CS_{1D}); and
generating an LED current control signal (CS_{2D});
operating a first buffer (307), coupled to the digital signal processor from a medium level supply voltage,wherein the medium level supply voltage is greater than the digital level supply voltage, by performing the steps of:
receiving the PFC control signal (CS_{1D}); and
converting the PFC control signal (CS_{1D}) into the PFC switch control signal (CS₁) to control the conductivity of the PFC switch;
operating a second buffer (309), coupled to the digital signal processor from the medium level supply voltage, by performing the steps of:
receiving the LED current control signal (CS_{2D}); and
converting the LED current control signal (CS_{2D}) into an LED current control switch signal (CS₂) to control the conductivity of the LED current control switch.

8. The method of claim 7 wherein the integrated circuit PFC and LED driver controller (305, 1512) includes a voltage feedback node to receive an input voltage feedback signal representing an input voltage level provided to the LED lighting system, further comprising:
generating the PFC control signal (CS_{1D}) in response to the input voltage level represented by the input voltage feedback signal; and
generating the LED current control signal (CS_{2D}) in response to the at least one current level represented by the LED current feedback signal.

9. The method of claim 7 wherein the digital level supply voltage is in the range of 3 volts to 8 volts, the medium level supply voltage is in the range of 8 volts to 50 volts, and the PFC switch (308, 1502) is coupled between voltage nodes having a voltage difference during normal operation of the LED lighting system of at least 100 volts, and the LED current control switch (310, 1504) is coupled between voltage nodes having a voltage difference during normal operation of the LED lighting system of at least 100 volts.

10. The method of claim 7 further comprising:
generating a link voltage (V_{C1}) from a primary supply-voltage (Vₓ);
operating a switching power converter (303, 402) of the LED lighting system from the primary supply voltage (Vₓ) relative to a common voltage reference node (V_{com}), wherein the switching power converter includes the PFC switch (308, 1502);
operating the PFC switch (308, 1502) at a control node-to-common node, absolute voltage to allow the integrated circuit PFC and LED drive controller to control the PFC switch and provide power factor correction for the switching power converter;
operating the LED current control switch (310, 1504) at a control node-to-common node, absolute voltage to allow the integrated circuit PFC and LED drive controller to control the LED current control switch to supply an approximately constant current to the at least one LED load for each dimming level indicated by a dimmer signal; and
controlling the conductivity of the PFC switch (308, 1502) and the LED current control switch (310, 1504) with the integrated circuit PFC and LED drive controller (305, 1512).

11. The method of claim 10 wherein:
operating the PFC switch (308, 1502) of the switching power converter at a control node-to-common node, absolute voltage to allow the integrated circuit PFC and LED drive controller to control the PFC switch and provide power factor correction for the switching power converter comprises operating the PFC switch (308, 1502) at a control node-to-common node, absolute voltage less than or equal to 0.15 times the first source voltage relative to the common voltage reference node (V_{com}); and
operating the LED current control switch (310, 1504) at a control node-to-common node, absolute voltage to allow the integrated circuit PFC and LED drive controller to control the LED current control switch to supply an approximately constant current to the at least one LED load for each dimming level indicated by a dimmer signal comprises operating the LED current control switch (310,1504) at a control node-to-common node, absolute voltage less than or equal to 0.15 times the first source voltage relative to the common voltage reference node (V_{com}).

12. The method of claim 10 wherein the PFC and LED current control switches comprise field effect transistors and controlling the conductivity of the PFC switch (308, 1502) and LED current control switch (310, 1504) with the integrated circuit PFC and LED drive controller comprises providing respective duty cycle modified control signals to gates of the PFC switch and LED current control switch.

13. The method of claim 10 further comprising:
receiving the primary supply voltage (Vₓ), wherein a root mean square (RMS) value of the primary supply voltage (Vₓ) is greater than the medium level voltage;
boosting the primary supply voltage (Vₓ) to the link voltage (V_{C1}), wherein boosting the primary supply voltage (Vₓ) further comprises modulating the conductivity of the PFC switch (308, 1502) to generate a power factor corrected primary supply voltage.

14. The method of claim 10 wherein controlling the conductivity of the LED current control switch (310, 1504) further comprises:
receiving the LED current feedback signal (LEDiₛₑₙₛₑ) from the at least one LED load; and
responding to the LED current feedback signal to maintain a predetermined current to the at least one LED load.

15. The method of claim 14 further comprising:
sensing a voltage across a resistor (314) representing a current through the at least one LED load (304), wherein the voltage sensed across the resistor (314) is the LED current feedback signal (LEDiₛₑₙₛₑ).

16. The method of claim 10 further comprising:
operating additional LED current control switches at respective control node-to-common node, absolute voltages less than or equal to 0.15 times the link voltage relative to the common voltage reference node (V_{com}), wherein each LED current control switch (310, 1504) is adapted to control the current through a respective chain of LEDs of the at least one LED load (304, 304.0-304.N) and wherein each chain of LEDs includes at least one LED;
receiving a LED current feedback signal representing a respective current conducted by each LED current control switch; and
controlling the conductivity of each LED current control switch (310, 1504) with the integrated circuit PFC and LED drive controller in response to the respective LED current feedback signal.

17. The method of claim 16 wherein controlling the conductivity of each LED current control switch (310, 1504) with the integrated circuit PFC and LED drive controller in response to the respective LED current feedback signal comprises:
determining during separate periods of time the respective currents conducted by each LED current control switch.

18. The method of claim 10 further comprising:
receiving a dimmer signal; and
wherein controlling the conductivity of the PFC switch (308, 1502) and the LED current control switch (310, 1504) further comprises:
concurrently controlling the conductivity of the PFC switch and the LED current control switch in accordance with changes in a dimming level indicated by the dimmer signal.

19. The method of claim 10 wherein the control node-to-common node, absolute voltage is less than or equal to approximately 15% of the link voltage (V_{C1}) to the common voltage reference node (V_{com}).

## Patentansprüche

1. Leuchtdiode, LED, Beleuchtungssystem mit:
mindestens einer LED-Last (304, 304.0-304.N) mit mindestens einer LED (602);
einen LED-Rückkopplungsknoten (313), der angepasst ist, um ein LED-Stromrückkopplungssignal (LEDiₛₑₙₛₑ) zu Verfügung zu stellen die mindestens einen Strompegel in der mindestens einen LED-Last repräsentiert und;
einen PFC-Schalter (308, 1502);
einen LED-Stromsteuerschalter (310, 1504), der dazu ausgelegt ist den Strom in der mindestens einen LED-Last zu steuern
eine integrierte Leistungsfaktorkorrektur, PFG und LED-Laufwerk eine integrierte Schaltungsleistungsfaktorkorrektur, PFG und eine LED-Antriebssteuerung (305, 1512), **dadurch gekennzeichnet, dass** die Steuerung folgendes umfasst:
einen digitalen Signalprozessor (DSP), der mit dem LED-Rückkopplungsknoten (313) gekoppelt und konfiguriert ist um:
von einer digitalen Versorgungsspannung zu arbeiten;
ein PFC-Steuersignal (CS_{1D}) zu erzeugen; und
ein LED-Stromsteuersignal (CS_{2D}) zu erzeugen;
einen ersten Puffer (307), der mit dem digitalen Signalprozessor gekoppelt und konfiguriert ist um:
von einer mittleren Versorgungsspannung (Vₐᵤₓ) zu arbeiten,
wobei die mittlere Versorgungsspannung größer als die digitale Pegelversorgungsspannung ist
das PFC-Steuersignals zu empfangen (CS_{1D}); und
das PFC-Steuersignal (CS_{1D}) in das PFC-Schalter-Steuersignal (CS₁) umzuwandeln, um die Leitfähigkeit des PFC-Schalters zu steuern; und
einen zweiten Puffer (309), der mit dem digitalen Signalprozessor gekoppelt und konfiguriert ist um:
von der mittleren Versorgungsspannung aus zu arbeiten;
das LED-Stromsteuersignal (CS_{2D}) zu empfangen; und
das LED-Stromsteuersignal (CS_{2D}) in ein LED-Stromregelschaltersignal (CS₂) umzuwandeln, um die Leitfähigkeit des LED-Stromregelschalters zu steuern.

2. LED-Beleuchtungssystem nach Anspruch 1, ferner umfassend:
einen gemeinsamen Spannungsreferenzknoten (V_{com});
einen ersten Spannungsquellenknoten, der dazu ausgelegt ist, eine primäre Versorgungsspannung (Vₓ) zu leiten;
einen zweiten Spannungsquellenknoten, der dazu ausgelegt ist, eine Verbindungsspannung (V_{C1}) des LED-Beleuchtungssystems zu leiten;
wobei der PFC-Schalter (308, 1502) mit dem gemeinsamen Spannungsreferenzknoten (V_{com}) und dem ersten Spannungsquellenknoten gekoppelt ist; und
wobei der LED-Stromsteuerschalter (310, 1504) mit dem gemeinsamen Spannungsreferenzknoten (V_{com}) und dem zweiten Spannungsquellenknoten gekoppelt ist;
wobei während des normalen Betriebs des LED-Beleuchtungssystems der PFC-Schalter und ein LED-Stromsteuerschalter jeweils einen Steuerknoten -zu-gemeinsamen Knoten aufweisen, wobei absolute Spannungen die integrierte Schaltung PFC- und LED-Antriebssteuerung zur Steuerung der Leitfähigkeit der Schalter und eine Leistungsfaktorkorrektur zur Verfügung stellen und für jede, durch ein Dimmersignal (Dᵥ) angezeigte Dimmstufe, einen annähernd konstanten Strom an die mindestens eine LED-Last liefern.

3. LED-Beleuchtungssystem nach Anspruch 2, wobei der Steuerknoten-zu-gemeinsame Knoten, die Absolutspannungen des PFC-Schalters (308, 1502) und der LED-Stromsteuerschalter (310, 1504) kleiner oder gleich dem 0,15-fachen einer Spannung der zweites Spannungsquellenknoten relativ zu einer Spannung an der Gemeinsamer Spannungsreferenzknoten (V_{com}) sind.

4. LED-Beleuchtungssystem nach Anspruch 2, wobei:
der PFC-Schalter (308, 1502) und der LED-Stromsteuerschalter (310, 1504) Mitglieder der Gruppe sind, bestehend aus: Feldeffekttransistoren und Bipolartransistoren mit isoliertem Gate.

5. LED-Beleuchtungssystem nach Anspruch 2 oder 3, ferner umfassend:
eine Stromerfassungseinrichtung (314), die mit dem LED-Stromsteuerschalter (310, 1504) und dem gemeinsamen Spannungsreferenzknoten (V_{com}) gekoppelt ist, wobei während des normalen Betriebs des LED-Beleuchtungssystems eine Spannung über der Stromerfassungseinrichtung (314) kleiner oder gleich dem 0,15-fachen einer Spannung an dem zweiten Spannungsquellenknoten relativ zu der Spannung am gemeinsamen Spannungsreferenzknoten (V_{com}) ist und wobei die Stromerfassungseinrichtung (314) konfiguriert ist, um das LED-StromRückkopplungssignal zum Steuern des LED-Stromsteuerschalters bereitzustellen.

6. LED-Beleuchtungssystem nach Anspruch 5, ferner umfassend:
eine Mehrzahl von LED-Stromsteuerschaltern (1104.0-1104.N, 1204.0-1204.N), die den LED-Stromsteuerschalter enthalten, wobei jeder LED-Stromsteuerschalter so konfiguriert ist, dass er einen Strom zu einem jeweiligen einer Mehrzahl von mindestens einer LED-Last (304, 304.0-304.N) steuert und mit dem gemeinsamen Spannungsreferenzknoten (V_{com}), dem zweiten Spannungsquellenknoten und dem integrierten Schaltkreis PFC und dem LED-Antriebsregler verbunden ist; und
wobei die Stromerfassungseinrichtung (314) mit den LED-Stromsteuerschaltern gekoppelt ist und wobei während des normalen Betriebs des Beleuchtungssystems die Stromerfassungseinrichtung (314) so konfiguriert ist, dass sie den Strom in allen LED-Stromsteuerschaltern zu erfühlen und um das LED-Stromsignal (LEDiₛₑₙₛₑ) zur Verwendung durch die integrierte Schaltung PFC und LED-Antriebsregler zur Steuerung des Stroms in allen LED-Stromregelschaltern bereitzustellen.

7. Verfahren zum Steuern eines PFC-Schalters (308, 1502) und eines LED-Stromsteuerschalters (310, 1504) einer lichtemittierenden Diode, einer LED-Beleuchtungsanlage wobei das LED-Beleuchtungssystem mindestens eine LED-Last (304, 304.0-304.N) und einen LED-Rückkopplungsknoten (313) aufweist, der so ausgelegt ist, dass er ein LED-Stromrückkopplungssignal (LEDiₛₑₙₛₑ) bereitstellt, das mindestens einen Erfassungsstrompegel in dem mindestens eine LED-Last repräsentiert, wobei die mindestens eine LED-Last mindestens eine LED enthält, **dadurch gekennzeichnet, dass** das Verfahren umfasst:
betreiben eines digitalen Signalprozessors (DSP) einer integrierten Schaltungsleistungsfaktorkorrektur PFG und einer LED-Antriebssteuerung (305, 1512) von einer digitalen Spannungsversorgung indem die folgenden Schritte ausführt werden:
erzeugen eines PFC-Steuersignals (CS_{1D}); und
erzeugen eines LED-Stromsteuersignals (CS_{2D});
betreiben eines ersten Puffers (307), der mit dem digitalen Signalprozessor von einer Mittelpegel-Versorgungsspannung gekoppelt ist, wobei die Mittelpegel-Versorgungsspannung größer als die digitale Pegel-Versorgungsspannung ist, indem die folgenden Schritte durchgeführt werden:
empfangen des PFC-Steuersignals (CS_{1D}); und
Umwandlung des PFC - Steuersignals (CS_{1D}) in das PFC - Schalter - Steuersignal (CS₁) zur Steuerung der Leitfähigkeit der PFC-Schalter;
Betreiben eines zweiten Puffers (309), der mit dem digitalen Signalprozessor von der Mittelpegel-Versorgungsspannung gekoppelt ist, durch Ausführen der folgenden Schritte:
Empfangen des LED-Stromsteuersignals (CS_{2D}); und Umwandeln des LED-Stromsteuersignals (CS_{2D}) in ein LED-Stromsteuerschaltersignal (CS₂), um die Leitfähigkeit des LED-Stromregelschalters zu steuern.

8. Verfahren nach Anspruch 7, wobei der integrierte Schaltkreis PFC und der LED-Treiber-Controller (305, 1512) einen Spannungsrückkopplungsknoten enthalten, um ein Eingangsspannungs-Rückkopplungssignal zu empfangen, das einen Eingangsspannungspegel darstellt, der an das LED-Beleuchtungssystem geliefert wird, weiter umfassend:
Erzeugen des PFC-Steuersignals (CS_{1D}) als Reaktion auf den Eingangsspannungspegel, der durch das Eingangsspannungs-Rückkopplungssignal repräsentiert wird; und
Erzeugen des LED-Stromsteuersignals (CS_{2D}) in Reaktion auf den mindestens einen Strompegel, der durch das LED-Stromrückkopplungssignal repräsentiert wird.

9. Verfahren nach Anspruch 7, wobei die Versorgungsspannung des digitalen Pegels im Bereich von 3 Volt bis 8 Volt liegt, die Versorgungsspannung des Mediumpegels im Bereich von 8 Volt bis 50 Volt liegt und der PFC-Schalter (308, 1502) zwischengeschaltet ist die bei normalem Betrieb des LED-Beleuchtungssystems von mindestens 100 Volt eine Spannungsdifferenz aufweisen, und der LED-Stromregelschalter (310, 1504) zwischen Spannungsknoten mit einer Spannungsdifferenz angekoppelt ist, die während des normalen Betriebs des LED-Beleuchtungssystems Mindestens 100volts beträgt.

10. Verfahren nach Anspruch 7, ferner umfassend:
Erzeugen einer Verbindungsspannung (V_{C1}) aus einer primären Versorgungsspannung (Vₓ);
Betreiben eines Schaltleistungswandlers (303, 402) des LED-Beleuchtungssystems von der Primärversorgungsspannung (Vₓ) relativ zu einem gemeinsamen Spannungsreferenzknoten (V_{com}), wobei der Schaltleistungswandler den PFC-Schalter (308, 1502) enthält;
Betreiben des PFC-Schalters (308, 1502) an einem Steuerknoten-zu-gemeinsamen Knoten, absolute Spannung, um dem integrierten Schaltkreis PFC und dem LED-Antriebsregler zu ermöglichen, den PFC-Schalter zu steuern und eine Leistungsfaktorkorrektur für den Schaltleistungswandler vorzusehen;
Betreiben des LED-Stromsteuerschalters (310, 1504) an einem Steuerknoten-zu- gemeinsamen Knoten, absolute Spannung, um dem integrierten Schaltkreis PFC und dem LED-Antriebsregler zu ermöglichen, den LED-Stromsteuerschalter zu steuern, um mindestens einen annähernd konstanten Strom zur LED-Last für jeden Dimmwert zuzuführen, der durch ein Dimmersignal angezeigt wird; und
Steuern der Leitfähigkeit des PFC-Schalters (308, 1502) und des LED-Stromsteuerschalters (310, 1504) mit der integrierten PFC Schaltung und der LED-Antriebssteuerung (305, 1512).

11. Verfahren nach Anspruch 10, wobei:
Betreiben des PFC-Schalters (308, 1502) des Schaltleistungswandlers an einem Steuerknoten-zu-gemeinsamen Knoten, absolute Spannung, um dem integrierten Schaltkreis PFC und dem LED-Antriebsregler die Steuerung des PFC-Schalters zu ermöglichen und eine Leistungsfaktorkorrektur für die Schaltleistung zu liefern Wandler umfasst das Betreiben des PFC-Schalters (308, 1502) an einem Steuerknoten-zu-gemeinsamen Knoten, eine absolute Spannung, die kleiner oder gleich dem 0,15-fachen der ersten Quellenspannung relativ zu dem gemeinsamen Spannungsreferenzknoten (V_{com}) ist; und
Betreiben des LED-Stromsteuerschalters (310, 1504) an einem Steuerknoten-zu- gemeinsamen Knoten, absolute Spannung, um dem integrierten Schaltkreis PFC und dem LED-Antriebsregler zu ermöglichen, den LED-Stromsteuerschalter zu steuern, um dem mindestens einen annähernd konstanten Strom zuzuführen die LED-Last für jeden Dimmpegel, der durch ein Dimmersignal angezeigt wird, umfasst das Betreiben des LED-Stromsteuerschalters (310, 1504) an einem Steuerknoten-zu-gemeinsamen Knoten, wobei die absolute Spannung kleiner oder gleich dem 0,15-fachen der ersten Quellenspannung relativ zu dem gemeinsamen Spannungsreferenzknoten (V_{com}) ist.

12. Verfahren nach Anspruch 10, wobei die PFC- und LED-Stromsteuerschalter Feldeffekttransistoren umfassen und die Leitfähigkeit des PFC-Schalters (308, 1502) und des LED-Stromsteuerschalters (310, 1504) steuern, wobei der integrierte Schaltkreis PFC und der LED-Antriebsregler das Bereitstellen des jeweiligen Tastverhältnisses umfassen, das modifizierte Steuersignale zu Gates des PFC-Schalters und des LED-Stromregelschalters bereitstellt.

13. Verfahren nach Anspruch 10, ferner umfassend:
Empfangen der Primärversorgungsspannung (Vₓ), wobei ein Wurzelmittelquadrat (RMS) der Primärversorgungsspannung (Vₓ) größer als die Mittelpegelspannung ist;
die Primärversorgungsspannung (Vx) zu verstärken um die Spannung (V_{C1}) zu verbinden, wobei die Verstärkung der Primärversorgungsspannung (Vₓ) ferner die Modulation der Leitfähigkeit des PFC-Schalters (308, 1502) umfasst, um eine Leistungsfaktorkorrektur-Primärversorgungsspannung zu erzeugen.

14. Verfahren nach Anspruch 10, bei dem die Leitfähigkeit des LED-Stromsteuerschalters gesteuert wird (310, 1504) und ferner folgendes aufweist:
Empfangen des LED-Stromrückkopplungssignals (LEDiₛₑₙₛₑ) von der mindestens einen LED-Last; und
Reaktion auf das LED-Stromrückkopplungssignal, um einen vorbestimmten Strom auf der mindestens eine LED-Last aufrechtzuerhalten.

15. Verfahren nach Anspruch 14, ferner umfassend:
Erfassen einer Spannung über einen Widerstand (314), der einen Strom durch die mindestens eine LED-Last (304) darstellt, wobei die über den Widerstand (314) erfasste Spannung das LED-Stromrückkopplungssignal (LEDiₛₑₙₛₑ) ist.

16. Verfahren nach Anspruch 10, ferner umfassend:
Betreiben von zusätzlichen LED-Stromregelschalter an dem jeweiligen Steuerknoten-zu-gemeinsamen Knoten, mit Absolutspannungen kleiner oder gleich dem 0,15-fachen der Verbindungsspannung relativ zu dem gemeinsamen Spannungsreferenzknoten (V_{com}), wobei jeder LED-Stromsteuerschalter (310, 1504) den Strom durch eine jeweilige Kette von LEDs der mindestens einen LED-Last (304, 304.0-304.N) steuert, und wobei jede Kette von LEDs mindestens eine LED enthält;
Empfangen eines LED-Stromrückkopplungssignals, das einen jeweiligen Strom darstellt, der von jedem LED-Stromsteuerschalter geleitet wird; und
Steuern der Leitfähigkeit jedes LED-Stromsteuerschalters (310, 1504) mit der integrierten Schaltung PFC und der LED-Antriebssteuerung in Reaktion auf das jeweilige LED-Stromrückkopplungssignal.

17. Verfahren nach Anspruch 16, wobei das Steuern der Leitfähigkeit jedes LED-Stromsteuerschalters (310, 1504) mit der integrierten Schaltung PFC und der LED-Antriebssteuerung in Reaktion auf das jeweilige LED-Stromrückkopplungssignal folgendes umfasst:
Bestimmen der jeweiligen Ströme während der getrennten Zeiträume, die von jedem LED-Stromsteuerschalter durchgeführt werden.

18. Verfahren nach Anspruch 10, ferner umfassend:
Empfangen eines Dimmersignals; und
wobei das Steuern der Leitfähigkeit des PFC-Schalters (308, 1502) und des LED-Stromsteuerschalters (310, 1504) ferner folgendes umfasst:
Gleichzeitiges Steuern der Leitfähigkeit des PFC-Schalters und des LED-Stromsteuerschalters in Übereinstimmung mit Änderungen in einem Dimmpegel, der durch das Dimmersignal angezeigt wird.

19. Verfahren nach Anspruch 10, wobei der Steuerknoten-zu-gemeinsame Knoten, die absolute Spannung kleiner oder gleich etwa 15 % der Verbindungsspannung (V_{C1}) zum gemeinsamen Spannungsreferenzknoten (V_{com}) ist.

## Revendications

1. Système d'éclairage à diode électroluminescente, LED, comprenant :
au moins une charge à LED (304, 304.0-304.N) incluant au moins une LED (602) ;
un noeud de rétroaction de LED (313) adapté pour fournir un signal de rétroaction de courant de LED (LEDiₛₑₙₛₑ) représentant au moins un niveau de courant dans l'au moins une charge à LED ; et
un commutateur à PFC (308, 1502) ;
un commutateur de commande de courant de LED (310, 1504) adapté pour commander le courant dans l'au moins une charge à LED ;
une unité de commande d'excitation de LED et à correction de facteur de puissance, PFC, à circuit intégré (305, 1512), **caractérisé en ce que** l'unité de commande comprend :
un processeur de signal numérique (DSP), couplé au noeud de rétroaction de LED (313), et configuré pour :
fonctionner à partir d'une tension d'alimentation de niveau numérique ;
générer un signal de commande à PFC (CS_{1D}) ; et
générer un signal de commande de courant de LED (CS_{2D}) ;
un premier circuit tampon (307), couplé au processeur de signal numérique, et configuré pour :
fonctionner à partir d'une tension d'alimentation de niveau moyen (Vₐᵤₓ),
dans lequel la tension d'alimentation de niveau moyen est supérieure à la tension d'alimentation de niveau numérique ;
recevoir le signal de commande à PFC (CS_{1D}) ; et
convertir le signal de commande à PFC (CS_{1D}) en le signal de commande de commutateur à PFC (CS₁) pour commander la conductivité du commutateur à PFC ; et
un second circuit tampon (309), couplé au processeur de signal numérique, et configuré pour :
fonctionner à partir de la tension d'alimentation de niveau moyen ;
recevoir le signal de commande de courant de LED (CS_{2D}) ; et
convertir le signal de commande de courant de LED (CS_{2D}) en un signal de commutateur de commande de courant de LED (CS₂) pour commander la conductivité du commutateur de commande de courant de LED.

2. Système d'éclairage à LED selon la revendication 1, comprenant en outre :
un noeud de référence de tension commune (V_{com}) ;
un premier noeud de source de tension adapté pour conduire une tension d'alimentation primaire (Vₓ) ;
un second noeud de source de tension adapté pour conduire une tension de liaison (V_{C1}) du système d'éclairage à LED ;
dans lequel le commutateur à PFC (308, 1502) est couplé au noeud de référence de tension commune (V_{com}) et au premier noeud de source de tension ; et
dans lequel le commutateur de commande de courant de LED (310, 1504) est couplé au noeud de référence de tension commune (V_{com}) et au second noeud de source de tension ;
dans lequel, durant le fonctionnement normal du système d'éclairage à LED, le commutateur à PFC et un commutateur de commande de courant de LED possèdent des tensions absolues respectives noeud de commande-à-noeud commun qui permettent à l'unité de commande d'excitation de LED et à PFC à circuit intégré de commander la conductivité des commutateurs et fournir une correction de facteur de puissance et fournir un courant approximativement constant à l'au moins une charge à LED pour chaque niveau de gradation d'intensité lumineuse indiqué par un signal de gradateur d'intensité lumineuse (D_{V}).

3. Système d'éclairage à LED selon la revendication 2, dans lequel les tensions absolues noeud de commande-à-noeud commun du commutateur à PFC (308, 1502) et du commutateur de commande de courant de LED (310, 1504) sont inférieures ou égales à 0,15 fois une tension au second noeud de source de tension par rapport à une tension au noeud de référence de tension commune (V_{com}).

4. Système d'éclairage à LED selon la revendication 2, dans lequel :
le commutateur à PFC (308, 1502) et le commutateur de commande de courant de LED (310, 1504) sont des membres du groupe constitué de : transistors à effet de champ et transistors bipolaires à porte isolée.

5. Système d'éclairage à LED selon la revendication 2 ou 3, comprenant en outre :
un dispositif de détection de courant (314) couplé au commutateur de commande de courant de LED (310, 1504) et au noeud de référence de tension commune (V_{com}), dans lequel, durant le fonctionnement normal du système d'éclairage à LED, une tension sur le dispositif de détection de courant (314) est inférieure ou égale à 0,15 fois une tension au second noeud de source de tension par rapport à la tension au noeud de référence de tension commune (V_{com}) et dans lequel le dispositif de détection de courant (314) est configuré pour fournir le signal de courant de LED pour commander le commutateur de commande de courant de LED.

6. Système d'éclairage à LED selon la revendication 5, comprenant en outre :
une pluralité de commutateurs de commande de courant de LED (1104.0-1104.N, 1204.0-1204.N) incluant le commutateur de commande de courant de LED, dans lequel chaque commutateur de commande de courant de LED est configuré pour commander le courant à l'une respective parmi une pluralité de l'au moins une charge à LED (304, 304.0-304.N) et est couplé au noeud de référence de tension commune (V_{com}), au second noeud de source de tension, et à l'unité de commande d'excitation de LED et à PFC à circuit intégré ; et
dans lequel le dispositif de détection de courant (314) est couplé aux commutateurs de commande de courant de LED, et dans lequel, durant le fonctionnement normal du système d'éclairage, le dispositif de détection de courant (314) est configuré pour détecter le courant dans la totalité des commutateurs de commande de courant de LED et pour fournir le signal de courant de LED (LEDiₛₑₙₛₑ) pour l'utilisation par l'unité de commande d'excitation de LED et à PFC à circuit intégré pour commander le courant dans la totalité des commutateurs de commande de courant de LED.

7. Procédé pour commander un commutateur à PFC (308, 1502) et un commutateur de commande de courant de LED (310, 1504) d'un système d'éclairage à diode électroluminescente, dans lequel le système d'éclairage à LED comprend au moins une charge à LED (304, 304.0-304.N) et un noeud de rétroaction de LED (313) adapté pour fournir un signal de rétroaction de courant de LED (LEDiₛₑₙₛₑ) représentant au moins un niveau de courant dans l'au moins une charge à LED, dans lequel l'au moins une charge à LED inclut au moins une LED, **caractérisé en ce que** le procédé comprend :
le fonctionnement d'un processeur de signal numérique (DSP) d'une unité de commande d'excitation de LED et à correction de facteur de puissance, PFC, à circuit intégré (305, 1512) à partir d'une tension d'alimentation de niveau numérique en réalisant les étapes de :
la génération d'un signal de commande à PFC (CS_{1D}) ; et
la génération d'un signal de commande de courant de LED (CS_{2D}) ;
le fonctionnement d'un premier circuit tampon (307), couplé au processeur de signal numérique à partir d'une tension d'alimentation de niveau moyen, dans lequel la tension d'alimentation de niveau moyen est supérieure à la tension d'alimentation de niveau numérique, en réalisant les étapes de :
la réception du signal de commande à PFC (CS_{1D}) ; et
la conversion du signal de commande à PFC (CS_{1D}) en le signal de commande de commutateur à PFC (CS₁) pour commander la conductivité du commutateur à PFC;
le fonctionnement d'un second circuit tampon (309), couplé au processeur de signal numérique à partir de la tension d'alimentation de niveau moyen, en réalisant les étapes de :
la réception du signal de commande de courant de LED (CS_{2D}) ; et la conversion du signal de commande de courant de LED (CS_{2D}) en un signal de commutateur de commande de courant de LED (CS₂) pour commander la conductivité du commutateur de commande de courant de LED.

8. Procédé selon la revendication 7, dans lequel l'unité de commande d'excitation de LED et à PFC à circuit intégré (305, 1512) inclut un noeud de rétroaction de tension pour recevoir un signal de rétroaction de tension d'entrée représentant un niveau de tension d'entrée fourni au système d'éclairage à LED, comprenant en outre :
la génération du signal de commande à PFC (CS_{1D}) en réponse au niveau de tension d'entrée représenté par le signal de rétroaction de tension d'entrée ; et
la génération du signal de commande de courant de LED (CS_{2D}) en réponse à l'au moins un niveau de courant représenté par le signal de rétroaction de courant de LED.

9. Procédé selon la revendication 7, dans lequel la tension d'alimentation de niveau numérique est dans la plage de 3 volts à 8 volts, la tension d'alimentation de niveau moyen est dans la plage de 8 volts à 50 volts, et le commutateur à PFC (308, 1502) est couplé entre des noeuds de tension possédant une différence de tension durant le fonctionnement normal du système d'éclairage à LED d'au moins 100 volts, et le commutateur de commande de courant de LED (310, 1504) est couplé entre des noeuds de tension possédant une différence de tension durant le fonctionnement normal du système d'éclairage à LED d'au moins 100 volts.

10. Procédé selon la revendication 7, comprenant en outre :
la génération d'une tension de liaison (V_{C1}) à partir d'une tension d'alimentation primaire (Vₓ) ;
le fonctionnement d'un convertisseur de puissance de commutation (303, 402) du système d'éclairage à LED à partir de la tension d'alimentation primaire (Vₓ) par rapport à un noeud de référence de tension commune (V_{com}), dans lequel le convertisseur de puissance de commutation inclut le commutateur à PFC (308, 1502) ;
le fonctionnement du commutateur à PFC (308, 1502) à une tension absolue noeud de commande-à-noeud commun pour permettre à l'unité de commande d'excitation de LED et à PFC à circuit intégré de commander le commutateur à PFC et fournir une correction de facteur de puissance pour le convertisseur de puissance de commutation ;
le fonctionnement du commutateur de commande de courant de LED (310, 1504) à une tension absolue noeud de commande-à-noeud commun pour permettre à l'unité de commande d'excitation de LED et à PFC à circuit intégré de commander le commutateur de commande de courant de LED de fournir un courant approximativement constant à l'au moins une charge à LED pour chaque niveau de gradation d'intensité lumineuse indiqué par un signal de gradateur d'intensité lumineuse ; et
la commande de la conductivité du commutateur à PFC (308, 1502) et du commutateur de commande de courant de LED (310, 1504) avec l'unité de commande d'excitation de LED et à PFC à circuit intégré (305, 1512).

11. Procédé selon la revendication 10, dans lequel :
le fonctionnement du commutateur à PFC (308, 1502) du convertisseur de puissance de commutation à une tension absolue noeud de commande-à-noeud commun pour permettre à l'unité de commande d'excitation de LED et à PFC à circuit intégré de commander le commutateur à PFC et fournir une correction de facteur de puissance pour le convertisseur de puissance de commutation comprend le fonctionnement du commutateur à PFC (308, 1502) à une tension absolue noeud de commande-à-noeud commun inférieure ou égale à 0,15 fois la première tension de source par rapport au noeud de référence de tension commune (V_{com}) ; et
le fonctionnement du commutateur de commande de courant de LED (310, 1504) à une tension absolue noeud de commande-à-noeud commun pour permettre à l'unité de commande d'excitation de LED et à PFC à circuit intégré de commander le commutateur de commande de courant de LED pour fournir un courant approximativement constant à l'au moins une charge à LED pour chaque niveau de gradation d'intensité lumineuse indiqué par un signal de gradateur d'intensité lumineuse comprend le fonctionnement du commutateur de commande de courant de LED (310, 1504) à une tension absolue noeud de commande-à-noeud commun inférieure ou égale à 0,15 fois la première tension de source par rapport au noeud de référence de tension commune (V_{com}).

12. Procédé selon la revendication 10, dans lequel les commutateurs à PFC et de commande de courant comprennent des transistors à effet de champ et la commande de la conductivité du commutateur à PFC (308, 1502) et du commutateur de commande de courant de LED (310, 1504) avec l'unité de commande d'excitation de LED et à PFC à circuit intégré comprend la fourniture de signaux de commande modifiés respectifs de cycle de service à des portes du commutateur à PFC et du commutateur de commande de courant de LED.

13. Procédé selon la revendication 10, comprenant en outre :
la réception de la tension d'alimentation primaire (Vₓ), dans lequel une valeur de moyenne quadratique (RMS) de la tension d'alimentation primaire (Vₓ) est supérieure à la tension de niveau moyen ;
l'augmentation de la tension d'alimentation primaire (Vₓ) à la tension de liaison (V_{C1}), dans lequel l'augmentation de la tension d'alimentation primaire (Vₓ) comprend en outre la modulation de la conductivité du commutateur à PFC (308, 1502) pour générer une tension d'alimentation primaire à facteur de puissance corrigée.

14. Procédé selon la revendication 10, dans lequel la commande de la conductivité du commutateur de commande de courant de LED (310, 1504) comprend en outre :
la réception du signal de rétroaction de courant de LED (LEDiₛₑₙₛₑ) à partir de l'au moins une charge à LED ; et
la réponse au signal de rétroaction de courant de LED pour maintenir un courant prédéterminé à l'au moins une charge à LED.

15. Procédé selon la revendication 14, comprenant en outre :
la détection d'une tension sur une résistance (314) représentant un courant à travers l'au moins une charge à LED (304), dans lequel la tension détectée sur la résistance (314) est le signal de rétroaction de courant de LED (LEDiₛₑₙₛₑ).

16. Procédé selon la revendication 10, comprenant en outre :
le fonctionnement de commutateurs de commande de courant de LED supplémentaires à des tensions absolues respectives noeud de commande-à-noeud commun inférieures ou égales à 0,15 fois la tension de liaison par rapport au noeud de référence de tension commune (V_{com}), dans lequel chaque commutateur de commande de courant de LED (310, 1504) est adapté pour commander le courant à travers une chaîne respective de LEDs de l'au moins une charge à LED (304, 304.0-304.N) et dans lequel chaque chaîne de LEDs inclut au moins une LED ;
la réception d'un signal de rétroaction de courant de LED représentant un courant respectif conduit par chaque commutateur de commande de courant de LED ; et
la commande de la conductivité de chaque commutateur de commande de courant de LED (310, 1504) avec l'unité de commande d'excitation de LED et à PFC à circuit intégré en réponse au signal respectif de rétroaction de courant de LED.

17. Procédé selon la revendication 16, dans lequel la commande de la conductivité de chaque commutateur de commande de courant de LED (310, 1504) avec l'unité de commande d'excitation de LED et à PFC à circuit intégré en réponse au signal respectif de rétroaction de courant de LED comprend :
la détermination, durant des périodes séparées, des courants respectifs conduits par chaque commutateur de commande de courant de LED.

18. Procédé selon la revendication 10, comprenant en outre :
la réception d'un signal de gradateur d'intensité lumineuse ; et
dans lequel la commande de la conductivité du commutateur à PFC (308, 1502) et du commutateur de commande de courant de LED (310, 1504) comprend en outre :
la commande simultanée de la conductivité du commutateur à PFC et du commutateur de commande de courant de LED conformément à des changements d'un niveau de gradation d'intensité lumineuse indiqué par le signal de gradateur d'intensité lumineuse.

19. Procédé selon la revendication 10, dans lequel la tension absolue noeud de commande-à-noeud commun est inférieure ou égale à approximativement 15 % de la tension de liaison (V_{C1}) par rapport au noeud de référence de tension commune (V_{com}).
